(19) Europäisches Patentamt / European Patent Office / Office européen des brevets

(11) **EP 4 332 146 A1**

(12) **EUROPEAN PATENT APPLICATION**
published in accordance with Art. 153(4) EPC

(43) Date of publication:
**06.03.2024 Bulletin 2024/10**

(21) Application number: **22820186.9**

(22) Date of filing: **06.06.2022**

(51) International Patent Classification (IPC):
***C08G 61/12*** *(2006.01)* ***H01L 51/46*** *(2006.01)*

(52) Cooperative Patent Classification (CPC):
**H10K 85/00; C08G 61/12**

(86) International application number:
**PCT/JP2022/022804**

(87) International publication number:
**WO 2022/260007 (15.12.2022 Gazette 2022/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.06.2021 JP 2021095389**

(71) Applicants:
- **OSAKA UNIVERSITY**
  **Suita-shi**
  **Osaka 565-0871 (JP)**
- **Daihachi Chemical Industry Co., Ltd.**
  **Osaka-shi, Osaka 541-0053 (JP)**
- **National University Corporation**
  **Kyoto Institute of Technology**
  **Sakyo-ku**
  **Kyoto-shi, Kyoto 606-8585 (JP)**
- **Public University Corporation**
  **Nagoya City University**
  **Mizuho-ku**
  **Nagoya-shi**
  **Aichi 467-8601 (JP)**

(72) Inventors:
- **HIRAO, Toshikazu**
  **Suita-shi, Osaka 565-0871 (JP)**
- **AMAYA, Toru**
  **Nagoya-shi, Aichi 467-8501 (JP)**
- **KIRIYAMA, Kahori**
  **Higashiosaka-shi, Osaka 577-0056 (JP)**
- **TSUCHIYA, Keiho**
  **Higashiosaka-shi, Osaka 577-0056 (JP)**
- **INADA, Yuhi**
  **Kyoto-shi, Kyoto 606-8585 (JP)**
- **YAMAO, Takeshi**
  **Kyoto-shi, Kyoto 606-8585 (JP)**
- **OKAZAKI, Ryo**
  **Kyoto-shi, Kyoto 606-8585 (JP)**

(74) Representative: **Uexküll & Stolberg**
**Partnerschaft von**
**Patent- und Rechtsanwälten mbB**
**Beselerstraße 4**
**22607 Hamburg (DE)**

# (54) POLYTHIOPHENE COMPOUND AND CONDUCTIVE MATERIAL COMPOSITION

(57) The present invention provides an electrically conductive polymer having excellent electrical conductivity. A polythiophene compound comprising a structural unit of following general formula (A) (wherein L is alkylene or the like; each of $M^1$ and $M^2$ is independently an alkyl group, a hydrogen atom, an alkali metal, an alkaline earth metal or an ammonium group; $R^{1A}$ is a hydrogen atom, an alkyl group, an alkoxy group, an acyl group or a group represented by formula (15); and each of $L^1$, $M^{1c}$ and $M^{2c}$ are respectively the same as L, $M^1$ and $M^2$) and having a high absorbance ratio calculated by calculation formula ($A_{2000}/A_{407}$) from absorbance ($A_{2000}$) at the wavelength of 2,000 nm and absorbance ($A_{407}$) at the wavelength of 407 nm achieves excellent electrical conductivity. Further, an electrical conductive polymer of the present invention is useful as a material for solar cells.

EP 4 332 146 A1

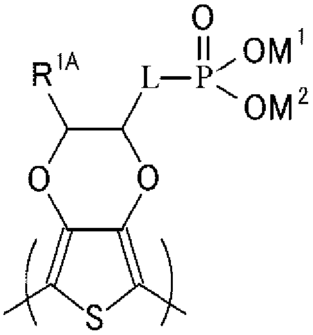

(A)

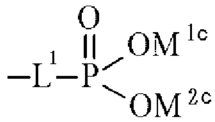

(15)

FIG.1

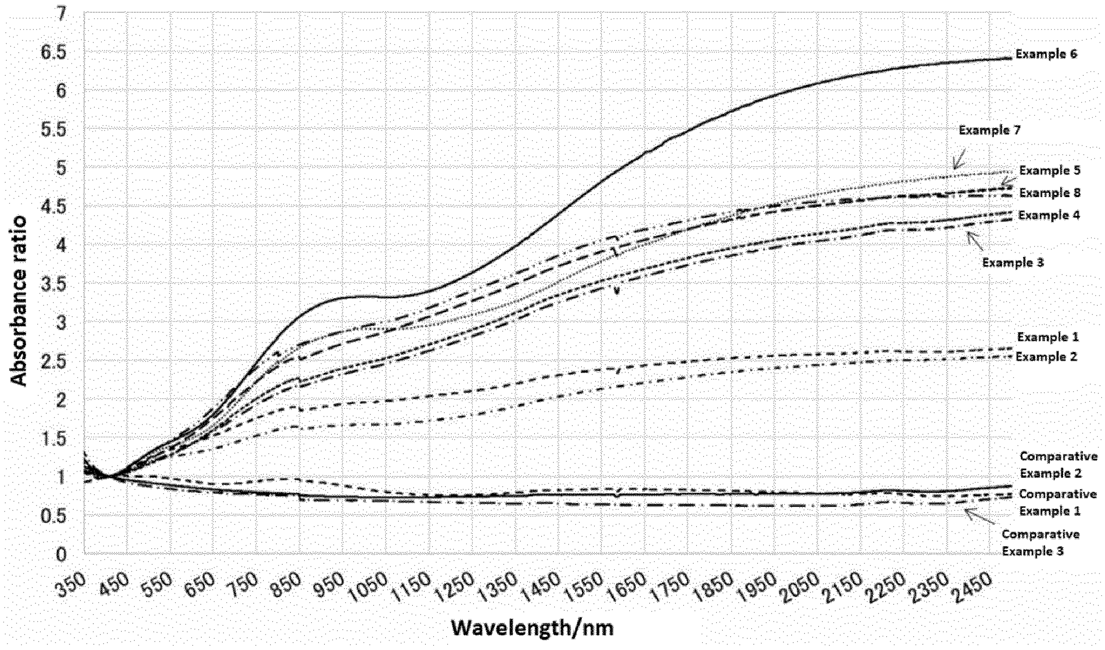
Example 6
Example 7
Example 5
Example 8
Example 4
Example 3
Example 1
Example 2
Comparative Example 2
Comparative Example 1
Comparative Example 3
Absorbance ratio
0
0.5
1
1.5
2
2.5
3
3.5
4
4.5
5
5.5
6
6.5
7
350 450 550 650 750 850 950 1050 1150 1250 1350 1450 1550 1650 1750 1850 1950 2050 2150 2250 2350 2450
Wavelength/nm

## Description

[Technical Field]

The present invention relates to a novel polythiophene compound, an electrically conductive material composition, and a manufacturing method thereof. More specifically, the present invention relates to a polythiophene compound that has expectation as antistatic agents, condensers, organic ELs, secondary cells, capacitors, static preventing agents, solar cells, electrode materials for plastic electrodes, EMI materials, organic ferromagnets, electrochromic materials, or various sensors, an electrically conductive material composition, and a manufacturing method thereof.

[Background Art]

Electrically conductive polymers represented by polythiophene, polypyrrole, polyaniline, and the like, are a group of compounds that have been actively developed in recent years in the field of "organic electronics".
Various mechanisms of electrical conductivity of polythiophene have been studied. It is known that a state of polaron or a state of bipolaron occurs on a main chain of polythiophene as one of the mechanisms. It is also known that a polaron state and a bipolaron state are associated with electrical conductivity, and electrical conductivity is achieved particularly by a main chain being in a bipolaron state.
Also, it is known that in the case of a compound having an acidic substituent on a side chain of polythiophene, the acidic substituent affects the state of electrons on the main chain, so that a bipolaron state is relatively readily formed, and as a result, the electrical conductivity is improved. Such a phenomenon of an acidic substituent on a side chain improving electrical conductivity is referred to as "self-doping" .
Patent Document 1 discloses a polythiophene compound having a phosphorous based structural unit as a polythiophene resin having electrical conductivity. It is understood that the phenomenon of self-doping occurs in the polythiophene compound of Patent Document 1 due to an acidic substituent on the side chain thereof. However, the electrical conductivity achieved in the Examples of Patent Document 1 is relatively low, which is not sufficient when used in an application requiring high electrical conductivity. Thus, there was a need for materials having higher electrical conductivity. Further, the state of electrons in molecules and bipolaron state were unknown in Patent Document 1.
Patent Document 2 describes that electrical conductivity is improved by performing copolymerization, but does not describe improving electrical conductivity of a homopolymer. Further, Patent Document 2 lacks a description of the state of electrons in a molecule or a bipolaron state.
Furthermore, Non-Patent Document 1 explains polythiophene having no phosphorous based structural unit, but does not describe polythiophene having a phosphorous based structural unit. Non-Patent Document 1 does not have any description of improving electrical conductivity of polythiophene having a phosphorous based structural unit, and only shows that absorption near 400 nm is not significantly affected by a phenomenon of a bipolaron state occurring on a main chain of a polythiophene compound.
Thus, conventional art did not have any guidance for improving electrical conductivity of the polythiophene compound disclosed in Patent Document 1. For this reason, those skilled in the art could not recognize whether or not there is room for improvement in electrical conductivity of the polythiophene compound disclosed in Patent Document 1.
Further, clean energy, which does not discharge substances that can be a cause of air pollution/global warming, such as carbon dioxide and nitrogen oxides, has drawn attention in view of heightened awareness for the global environment. An example thereof includes solar cells (solar power generation). In recent years, organic thin-film solar cells, which can reduce manufacturing cost relative to conventional solar cells (silicon based, and the like), have been actively studied. A poly(3,4-ethylenedioxythiophene) polystyrene sulfonate (PEDOT:PSS) which is an electrically conductive polymer is often used in a hole transport layer of the organic thin-film solar cell. However, sufficient performance cannot be deemed as being achieved, so that there is a desire for further improvement in performance, such as photoelectric conversion efficiency, life time or the like. Thus, there is a desire in the field of solar cells for an electrically conductive material composition, which improves the photoelectric conversion efficiency and life time by using in a hole transport layer of an organic thin-film solar cell.

[Prior Art Document]

[Patent Document]

[Patent Document 1] Japanese Laid-Open Publication No. 2018-48322
[Patent Document 2] Japanese Laid-Open Publication No. 2020-105500

[Non-Patent Document]

[Non-Patent Document 1] Trans. Mat. Res. Soc. Japan 37[2] 307-310 (2012)

[Summary of Invention]

[Problems to be solved by the invention]

The present invention provides a novel polythiophene compound and an electrically conductive material composition. The problem to be solved by the present invention is to provide novel a polythiophene compound and an electrically conductive material composition, which have excellent electrical conductivity.

[Means for Solving the Problem]

As a result of diligent studies, the inventors have completed the present invention by finding that the problem to be solved described above is solved by a polythiophene compound having a high absorbance ratio, which represents the relative strength of absorbance due to bipolaron measured with a spectrophotometer.

Since absorbance reflects the state of electrons that are present in a molecule, the absorbance ratio also reflects the state of electrons that are present in a molecule. Thus, a fact that there is a difference in the absorbance ratio means that there is a difference in the state of electrons in a molecule. Specifically, a compound having a low absorbance ratio and a compound having a high absorbance ratio have different states of electrons in a molecule. A compound having a low absorbance ratio and a compound having a high absorbance ratio are different compounds in this regard. The problem described above has been solved in the present invention by a compound having a high absorbance ratio.

Specifically, the inventors found that in the polythiophene compound disclosed in above-described Patent Document 1 (Japanese Laid-Open Publication No. 2018-48322), absorbance ($A_{2000}$) of the compound at a wavelength of 2000 nm measured using a spectrophotometer is lower compared to absorbance ($A_{407}$) of said compound at a wavelength of 407 nm. As a result of proceeding with studies noting on this point, the inventors found that dramatically high electrical conductivity can be achieved by a compound having a high absorbance ratio calculated using a calculation formula ($A_{2000}/A_{407}$) from absorbance ($A_{2000}$) of said compound at a wavelength of 2000 nm and absorbance ($A_{407}$) of said compound at a wavelength of 407 nm measured using a spectrophotometer.

Specifically, the present invention provides the following compounds, and the like.

(Item 1)

A polythiophene compound comprising a structural unit represented by the following general formula (A):

[Chemical Formula 1]

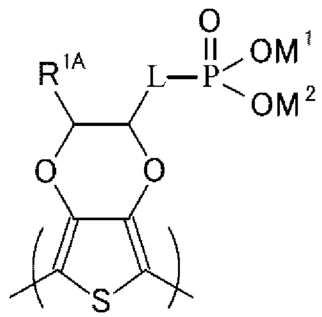

(A)

wherein L is represented by formula (21):

[Chemical Formula 21]

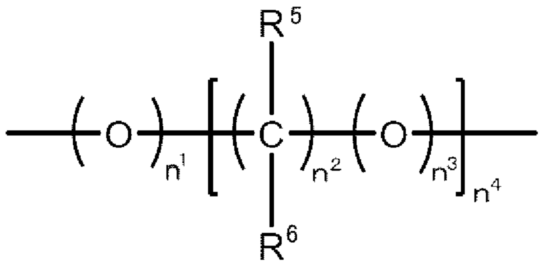

(21)

wherein $R^5$ is independently a hydrogen atom or a straight chain or branched chain alkyl group in which the number of carbon atoms is 1 to 5, $R^6$ is independently a hydrogen atom or a straight chain or branched chain alkyl group in which the number of carbon atoms is 1 to 5, $n^1$ is 0 or 1, $n^2$ is independently an integer from 1 to 6, $n^3$ is independently 0 or 1, $n^4$ is an integer from 0 to 12, and the left end of formula (21) is bound to the carbon atom in the dioxane ring in formula (A),

$M^1$ and $M^2$ are each independently an alkyl group in which the number of carbon atoms is 1 to 15, a hydrogen atom, an alkali metal, an alkaline earth metal, or an ammonium group, with the proviso that if one of $M^1$ and $M^2$ is an alkaline earth metal, then the compound has a structure in which the alkaline earth metal atom is bound to two $O^-$ in one phosphoric acid or phosphonic acid moiety and the other of $M^1$ and $M^2$ is not present, or the compound has a structure in which the alkaline earth metal atom crosslinks $O^-$ of two phosphoric acid or phosphonic acid moieties, if at least one of $M^1$ and $M^2$ is a hydrogen atom, then the compound may be bound to a basic substance at a moiety of the hydrogen atom to form a salt,

$R^{1A}$ is a hydrogen atom, an alkyl group, an alkoxy group, an acyl group, or a group represented by formula (15):

[Chemical Formula 15]

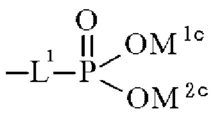

(15)

wherein $L^1$ is represented by formula (22):

[Chemical Formula 22]

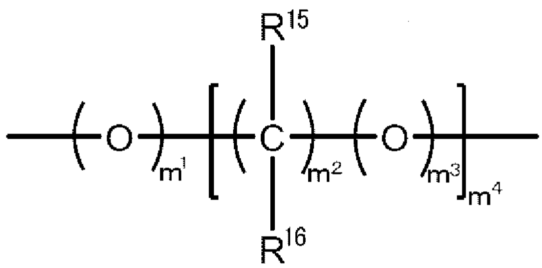

(22)

wherein $R^{15}$ is independently a hydrogen atom or a straight chain or branched chain alkyl group in which the number of carbon atoms is 1 to 5, $R^{16}$ is independently a hydrogen atom or a straight chain or branched chain alkyl group in which the number of carbon atoms is to 5, $m^1$ is 0 or 1, $m^2$ is independently an integer from 1 to 6, $m^3$ is independently 0 or 1, $m^4$ is an integer from 0 to 12, and the left end of formula (22) is bound to the carbon atom in the dioxane ring in formula (A),

$M^{1c}$ and $M^{2c}$ are each independently an alkyl group in which the number of carbon atoms is 1 to 15, a hydrogen atom, an alkali metal, an alkaline earth metal, or an ammonium group, with the proviso that if one of $M^{1c}$ and $M^{2c}$ is an alkaline earth metal, then the compound has a structure in which the alkaline earth metal atom is bound to two $O^-$ in one phosphoric acid or phosphonic acid moiety and the other of $M^{1c}$ and $M^{2c}$ is not present, or the compound

has a structure in which the alkaline earth metal atom crosslinks $O^-$ of two phosphoric acid or phosphonic acid moieties, if at least one of $M^{1c}$ and $M^{2c}$ is a hydrogen atom, then the compound may be bound to a basic substance at a moiety of the hydrogen atom to form a salt,

wherein an absorbance ratio calculated using a calculation formula ($A_{2000}/A_{407}$) from absorbance ($A_{2000}$) of the compound at a wavelength of 2000 nm and absorbance ($A_{407}$) of the compound at a wavelength of 407 nm measured using a spectrophotometer is 1 or greater.

(Item 2)

An electrically conductive material composition comprising a polythiophene compound,

the polythiophene compound comprising a structural unit represented by the following general formula (A):

[Chemical Formula 1]

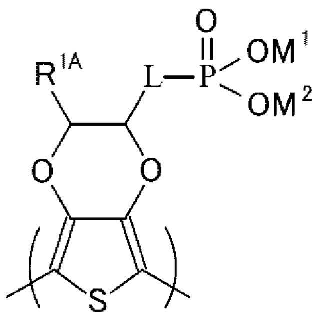

(A)

wherein L is represented by formula (21):

[Chemical Formula 21]

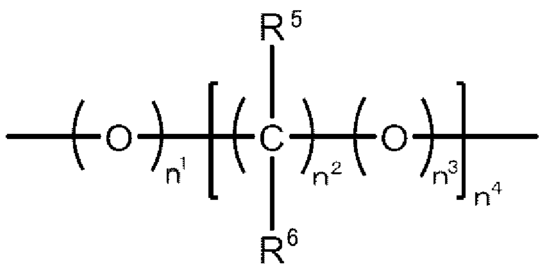

(21)

wherein $R^5$ is independently a hydrogen atom or a straight chain or branched chain alkyl group in which the number of carbon atoms is 1 to 5, $R^6$ is independently a hydrogen atom or a straight chain or branched chain alkyl group in which the number of carbon atoms is 1 to 5, $n^1$ is 0 or 1, $n^2$ is independently an integer from 1 to 6, $n^3$ is independently 0 or 1, $n^4$ is an integer from 0 to 12, and the left end of formula (21) is bound to the carbon atom in the dioxane ring in formula (A),

$M^1$ and $M^2$ are each independently an alkyl group in which the number of carbon atoms is 1 to 15, a hydrogen atom, an alkali metal, an alkaline earth metal, or an ammonium group, with the proviso that if one of $M^1$ and $M^2$ is an alkaline earth metal, then the compound has a structure in which the alkaline earth metal atom is bound to two $O^-$ in one phosphoric acid or phosphonic acid moiety and the other of $M^1$ and $M^2$ is not present, or the compound has a structure in which the alkaline earth metal atom crosslinks $O^-$ of two phosphoric acid or phosphonic acid moieties, if at least one of $M^1$ and $M^2$ is a hydrogen atom, then the compound may be bound to a basic substance at a moiety of the hydrogen atom to form a salt,

$R^{1A}$ is a hydrogen atom, an alkyl group, an alkoxy group, an acyl group, or a group represented by formula (15):

[Chemical Formula 15]

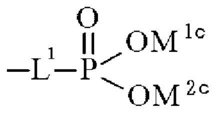

(15)

wherein $L^1$ is represented by formula (22):

[Chemical Formula 22]

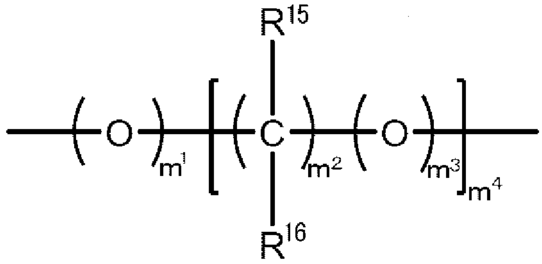

(22)

wherein $R^{15}$ is independently a hydrogen atom or a straight chain or branched chain alkyl group in which the number of carbon atoms is 1 to 5, $R^{16}$ is independently a hydrogen atom or a straight chain or branched chain alkyl group in which the number of carbon atoms is 1 to 5, $m^1$ is 0 or 1, $m^2$ is independently an integer from 1 to 6, $m^3$ is independently 0 or 1, $m^4$ is an integer from 0 to 12, and the left end of formula (22) is bound to the carbon atom in the dioxane ring in formula (A),

$M^{1c}$ and $M^{2c}$ are each independently an alkyl group in which the number of carbon atoms is 1 to 15, a hydrogen atom, an alkali metal, an alkaline earth metal, or an ammonium group, with the proviso that if one of $M^{1c}$ and $M^{2c}$ is an alkaline earth metal, then the compound has a structure in which the alkaline earth metal atom is bound to two $O^-$ in one phosphoric acid or phosphonic acid moiety and the other of $M^{1c}$ and $M^{2c}$ is not present, or the compound has a structure in which the alkaline earth metal atom crosslinks $O^-$ of two phosphoric acid or phosphonic acid moieties, if at least one of $M^{1c}$ and $M^{2c}$ is a hydrogen atom, then the compound may be bound to a basic substance at a moiety of the hydrogen atom to form a salt,

wherein an absorbance ratio calculated using a calculation formula ($A_{2000}/A_{407}$) from absorbance ($A_{2000}$) of the composition at a wavelength of 2000 nm and absorbance ($A_{407}$) of the composition at a wavelength of 407 nm measured using a spectrophotometer is 1 or greater.

(Item 3)

The compound of item 1 or the electrically conductive material composition of item 2, wherein the absorbance ratio is 2 or greater.

(Item 4)

The compound of item 1 or the electrically conductive material composition of item 2 or 3, wherein at least one of $M^1$ and $M^2$ comprises a structural unit selected from a hydrogen atom, an alkali metal, an alkaline earth metal, and an ammonium group.

(Item 5)

The compound of item 1 or the electrically conductive material composition of any one of items 2 to 4, wherein $R^{1A}$ is hydrogen, an alkyl group, an alkoxy group, or an acyl group.

(Item 6)

The compound of item 1 or the electrically conductive material composition of any one of items 2 to 5, wherein $R^{1A}$ is hydrogen.

(Item 7)

The compound of item 1 or the electrically conductive material composition of any one of items 2 to 6, wherein $n^1$ is 0, $n^2$ is independently an integer from 1 to 4, $n^4$ is 1 or 2, and $R^5$ and $R^6$ are each independently hydrogen or a straight chain or branched chain alkyl group in which the number of carbon atoms is 1 to 3.

(Item 8)

The compound of item 1 or the electrically conductive material composition of any one of items 2 to 7, wherein $n^1$ and $n^3$ are 0, $n^2$ and $n^4$ are 1, and $R^5$ and $R^6$ are hydrogen.

(Item 9)

A method of manufacturing the compound of item 1 or the electrically conductive material composition of any one of items 2 to 8, comprising:

subjecting a thiophene monomer corresponding to the polythiophene compound to oxidative polymerization in the presence of an oxidizing agent; and
purifying the obtained polymerization product by using a chelate compound to prepare the compound of item 1 or the electrically conductive material composition of any one of items 2 to 8.

(Item 10)

The method of item 9, wherein the oxidizing agent comprises an oxidizing agent comprising an iron atom.

(Item 11)

The method of item 9 or 10, wherein the chelate compound is a compound having a plurality of phosphonic acid structural moieties ($-P(=O)(OH)_2$).

(Item 12)

An organic thin-film solar cell having a hole transport layer comprising the electrically conductive material composition of any one of items 2 to 8.
A polythiophene compound and an electrically conductive resin composition manufactured by the manufacturing method of any of above-described items 9 to 11 are provided in one embodiment of the present invention.

[Effect of Invention]

The polythiophene compound of the present invention exhibits significantly higher and better electrical conductivity than conventional polythiophene compounds. For this reason, the polythiophene compound of the present invention has expectation for application to the field of electronic materials.

[Brief Description of Drawings]

[Figure 1] Figure 1 is a graph showing the absorbance ratio at each wavelength of the polythiophene compounds obtained in Examples 1 to 8 and Comparative Examples 1 to 3. The horizontal axis indicates the wavelength (nm) and the vertical axis indicates the absorbance ratio. The figure shows that the absorbance ratio at a wavelength of 2000 nm in Comparative Examples 1 to 3 is less than 1. Meanwhile, the figure shows that the absorbance ratio at a wavelength of 2000 nm in Examples 1 to 8 is 2.4 to 6.
[Figure 2] Figure 2 shows a laminated structure of one example of a solar cell device.
[Figure 3] Figure 3 shows an example of a solar cell device, to which a voltage applying device is connected. The arrow indicates irradiation of simulated solar light (100 $mWcm^{-2}$).
[Figure 4] Figure 4 is a graph showing the relationship of parameters and current density-voltage (J-V) characteristics and shows schematic J-V characteristics.
[Figure 5] Figure 5 is a graph showing the J-V characteristics of a solar cell device.

[Figure 6] Figure 6 is a graph showing the change in PCE of a solar cell device over time.

[Embodiments for Carrying Out the Invention]

The present invention is described in detail hereinafter.

While the polythiophene compound of the present invention has a chemical structural formula described below, it is difficult to specify the chemical structure thereof by a strictly accurate chemical structural formula. The reason thereof is described hereinafter.

Since a phenomenon of self-doping occurs in a polythiophene compound as described above with regard to conventional art, it is considered that a polaron or bipolaron state occurs on the main chain of the polythiophene compound. However, it is realistically extremely difficult to actually determine a structure in a polaron or bipolaron state accurately. Further, a polaron or bipolaron state does not always occur over the full length of the main chain of one polythiophene compound from end to end. There is a possibility that a polaron or bipolaron state may occur only at a moiety of a main chain. Furthermore, when there are a plurality of molecules, a polaron or bipolaron state does not always occur in all of the molecules. There is also a possibility that a polaron or bipolaron state may occur in only some of the molecules. For this reason, it is impossible to quantitatively accurately describe, by a chemical structural formula, such a polythiophene compound wherein a polaron or bipolaron state occurs only at a moiety of a molecule or only at some of the molecules.

Therefore, in the present specification, the term "polythiophene compound" has a meaning that encompasses all of (a) a polythiophene compound, which is in neither a polaron nor bipolaron state, (b) a polythiophene compound in a polaron state, and (c) a polythiophene compound in a bipolaron state, unless it is particularly described that the term "polythiophene compound" is limited. Further, if there is no description that particularly limits the chemical structural formula of a polythiophene compound in the present specification, then the chemical structural formula has a meaning that encompasses all of (a) a polythiophene compound, which is in neither a polaron nor bipolaron state, (b) a polythiophene compound in a polaron state, and (c) a polythiophene compound in a bipolaron state.

High electrical conductivity is achieved in the present invention by a polythiophene compound having a specific absorbance ratio. Specifically, the polythiophene compound of the present invention has an absorbance ratio calculated using a calculation formula ($A_{2000}/A_{407}$) from absorbance ($A_{2000}$) of the compound at a wavelength of 2000 nm and absorbance ($A_{407}$) of the compound at a wavelength of 407 nm measured using a spectrophotometer of 1 or greater. The absorbance ratio is preferably 1.5 or greater, more preferably 2 or greater, still preferably 2.5 or greater, and particularly preferably 3 or greater. Optionally, the absorbance ratio may be 3.5 or greater, 4 or greater, or 4.5 or greater. There is no particular upper limit for an absorbance ratio. However, the upper limit of an absorbance ratio may be optionally set to, for example, 10 or less, 8 or less, or 6 or less.

Since absorbance reflects the state of electrons that are present in a molecule, the absorbance ratio also reflects the state of electrons that are present in a molecule. Thus, a fact that there is a difference in the absorbance ratios means that there is a difference in the state of electrons in a molecule. Specifically, a compound having a low absorbance ratio and a compound having a high absorbance ratio have different states of electrons in a molecule. A compound having a low absorbance ratio and a compound having a high absorbance ratio are different compounds in this regard.

It is considered from above-described Non-Patent Document 1 that absorbance at a wavelength of 407 nm is not significantly affected by a phenomenon of a bipolaron state which occurs on the main chain of a polythiophene compound. On the other hand, it is considered that high absorbance at a wavelength of 2000 nm is measured when a bipolaron state occurs. Thus, it is understood that if the absorbance ratio is high, then the density of a bipolaron state is high. For example, it is expected that a phenomenon occurs wherein the range where a hole can be delocalized on the main chain is extended so that the ratio of the length of a range where a hole can be delocalized to the entire length of the main chain would be greater, or the like.

In addition, it is understood that the level of a bipolaron state on the main chain is low in a compound having a low absorbance ratio, and the level of a bipolaron state on the main chain is high in a compound having a high absorbance ratio. Further, it is understood that a compound having a high absorbance ratio achieves excellent electrical conductivity due to this difference.

[Polythiophene compound]

A polythiophene compound is represented by, for example, general formula (12):

$$-(A)_q- \qquad (12)$$

wherein A is each independently a thiophene monomer residue. q is the degree of polymerization, which is any positive integer. Specifically, q can be, for example, 3 or greater, 6 or greater, or 10 or greater, and q can be 2,000 or less, 1,000

or less, 800 or less, or 400 or less.

It should be noted that when the structure of a polythiophene compound is described as a general formula, both ends thereof are generally omitted. Thus, in the present specification, in principle, both ends are omitted when describing the structure of a polythiophene compound. However, if both ends of the aforementioned general formula (12) are described, it would result in, for example, the following general formula (12A):

$$E^1-(A)_q-E^2 \quad (12A)$$

wherein each of $E^1$ and $E^2$ is an end group. Generally, one is a polymerization initiation end and the other is a polymerization termination end.

A polythiophene compound is preferably a homopolymer. However, a polythiophene compound may be a copolymer as needed. A copolymer may be a block copolymer or may be a random copolymer.

It should be noted that in the present specification, a unit constituting a repeat structure of a polymer is referred to as a structural unit. Specifically, "A" is a structural unit in the polymer of the above-described general formula (12A). The polymer is comprised of the structural units and the end groups. In other words, moieties other than the polymerization initiation end and the polymerization termination end of the polymer are comprised of the structural units. Thus, in the present specification, a description of "polythiophene compound does not comprise a structural unit other than general formula (A)" means that moieties other than the end groups are comprised of only the structural units of general formula (A).

The polythiophene compound of the present invention comprises a structural unit represented by the following general formula (A):

[Chemical Formula 1]

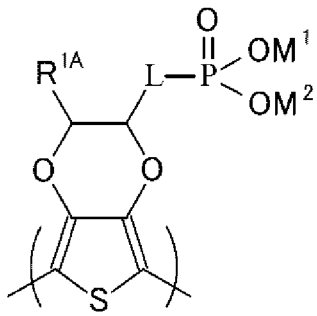

(A)

.

In general formula (A), L is represented by formula (21):

[Chemical Formula 21]

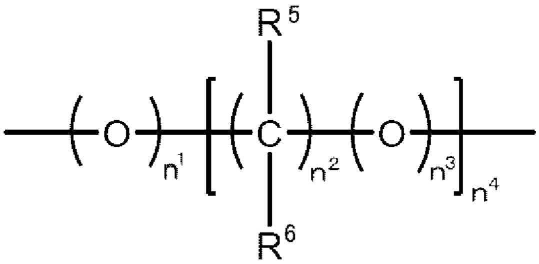

(21) .

In this regard, $R^5$ is independently a hydrogen atom or a straight chain or branched chain alkyl group in which the number of carbon atoms is 1 to 5, preferably a hydrogen atom or an alkyl group in which the number of carbon atoms is 1 to 3, and more preferably a hydrogen atom.

$R^6$ is independently a hydrogen atom or a straight chain or branched chain alkyl group in which the number of carbon atoms is 1 to 5, preferably a hydrogen atom or an alkyl group in which the number of carbon atoms is 1 to 3, and more preferably a hydrogen atom.

$n^1$ is 0 or 1, and is preferably 0.

$n^2$ is independently an integer from 1 to 6, preferably 1 to 4, more preferably 1 to 2, and still preferably 1.

$n^3$ is independently 0 or 1, and preferably 0. If $n^3$ is 0, then $n^4$ is preferably 1 or 2, and $n^4$ is more preferably 1.

$n^4$ is an integer from 0 to 12, preferably 0 to 6, more preferably 1 or 2, and still preferably 1.

The product of $n^2$ and $n^4$ would be the total number of carbons atoms between the dioxane ring and the phosphorous.

(Number of carbon atoms between a dioxane ring and phosphorous) = $n^2 \times n^4$

The number of the carbon atoms between the dioxane ring and the phosphorous is preferably 1 to 12, more preferably 1 to 9, still preferably 1 to 6, and particularly preferably 1 to 3. In one embodiment, the number of the carbon atoms is 1 or 2.

The left end of formula (21) is bound to the carbon atom in the dioxane ring in formula (A), and the right end of formula (21) is bound to the phosphorous atom in formula (A).

In one embodiment, $R^5$ and $R^6$ are hydrogen atoms, $n^1$ is 0, $n^3$ is 0, and $n^4$ is 1. In other words, in this embodiment, L is - $(CH_2)_{n2}$-, wherein $n^2$ is independently 0 to 12. $n^2$ is preferably 0 to 4, and more preferably 0 to 2. $n^2$ is particularly preferably 1.

$M^1$ and $M^2$ are each independently an alkyl group in which the number of carbon atoms is 1 to 15, a hydrogen atom, an alkali metal, an alkaline earth metal, or an ammonium group. In one preferred embodiment, at least one of $M^1$ and $M^2$ is selected from a hydrogen atom, an alkali metal, an alkaline earth metal, and an ammonium group. Still preferably, both $M^1$ and $M^2$ are hydrogen atoms.

In general formula (A), $R^{1A}$ is a hydrogen atom, an alkyl group, an alkoxy group, an acyl group, or a group represented by formula (15), preferably an alkyl group or a hydrogen atom, and still preferably a hydrogen atom.

[Chemical Formula 15]

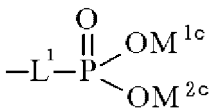

(15)

In the formula, $L^1$ is represented by formula (22):

[Chemical Formula 22]

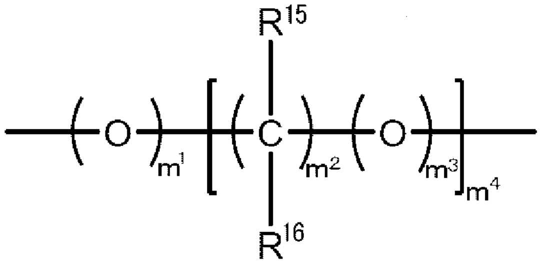

(22) .

In the formula, $R^{15}$ is independently a hydrogen atom or a straight chain or branched chain alkyl group in which the number of carbon atoms is 1 to 5, preferably a hydrogen atom or an alkyl group in which the number of carbon atoms is 1 to 3, and more preferably a hydrogen atom.

$R^{16}$ is independently a hydrogen atom or a straight chain or branched chain alkyl group in which the number of carbon atoms is 1 to 5, preferably a hydrogen atom or an alkyl group in which the number of carbon atoms is 1 to 3, and more preferably a hydrogen atom.

$m^1$ is 0 or 1, and preferably 0.

$m^2$ is independently an integer from 1 to 6, preferably 1 to 4, more preferably 1 to 2, and still preferably 1.

$m^3$ is independently 0 or 1, and preferably 0. If $m^3$ is 0, then $m^4$ is preferably 1 or 2, and more preferably $m^4$ is 1.

$m^4$ is an integer from 0 to 12, preferably 0 to 6, more preferably 1 or 2, and still preferably 1.

The product of $m^2$ and $m^4$ is the total number of the carbon atoms between the dioxane ring and the phosphorous. (number of the carbon atoms between the dioxane ring and the phosphorous) = $m^2 \times m^4$

The number of the carbon atoms between the dioxane ring and the phosphorous is preferably 1 to 12, more preferably 1 to 9, still preferably 1 to 6, particularly preferably 1 to 3, and in one embodiment 1 or 2.

The total of the number of carbon atoms between a dioxane ring and phosphorous in L and the number of carbon atoms between the dioxane ring and the phosphorous in $L^1$ is preferably 1 to 16, more preferably 1 to 12, still preferably 1 to 8, particularly preferably 1 to 4, and in one embodiment 1 or 2.

The left end of formula (22) is bound to the carbon atom in the dioxane ring in formula (A), and the right end of formula (22) is bound to a phosphorous atom in formula (15).

In one embodiment, $R^{15}$ and $R^{16}$ are hydrogen atoms, $m^1$ is 0, $m^3$ is 0, and $m^4$ is 1. In other words, in this embodiment, $L^1$ is - $(CH_2)_{m2}$-, wherein $m^2$ is independently 0 to 12. $M^{1c}$ and $M^{2c}$ are each independently an alkyl group in which the number of carbon atoms is 1 to 15, a hydrogen atom, an alkali metal, an alkaline earth metal, or an ammonium group, with the proviso that if one of $M^{1c}$ and $M^{2c}$ is an alkaline earth metal, then the compound has a structure in which the alkaline earth metal atom is bound to two $O^-$ in one phosphoric acid or phosphonic acid moiety and the other of $M^{1c}$ and $M^{2c}$ is not present, or the compound has a structure in which the alkaline earth metal atom crosslinks $O^-$ of two phosphoric acid or phosphonic acid moieties.

It should be noted that in the present specification, a phosphoric acid or phosphonic acid moiety refers to a moiety having a structure of a phosphoric acid group or a derivative thereof (e.g., a salt or ester) or a phosphonic acid group or a derivative thereof (e.g., a salt or ester). For example, in the present specification, a moiety where $M^1$ and $M^2$ of general formula (A) is bound to a phosphoric acid group or a phosphonic acid group, and a moiety where $M^{1c}$ and $M^{2c}$ of formula (15) is bound to a phosphoric acid group or a phosphonic acid group are also referred to as a phosphoric acid or phosphonic acid moiety.

In general formula (A), alkyl groups in $R^{1A}$ may be each independently straight chain, branched chain, or cyclic. A cyclic alkyl group may be comprised of only a cyclic structure, or may have a structure in which a chain alkyl group is further bound to the cyclic structure. The number of carbon atoms in an alkyl group is preferably 1 to 15, still preferably 1 to 8, and particularly preferably 1 to 4. Specific examples thereof include a methyl group, ethyl group, propyl group, butyl group, pentyl group, hexyl group, heptyl group, octyl group, nonyl group, decyl group, undecyl group, dodecyl group, tridecyl group, tetradecyl group, pentadecyl group, and the like.

Alkoxy groups in $R^{1A}$ may be each independently straight chain, branched chain, or cyclic. A cyclic alkoxy group may be comprised of only a cyclic structure, or may have a structure in which a chain alkyl group and/or chain alkoxy group is further bound to the cyclic structure. The number of carbon atoms in an alkoxy group is preferably 1 to 15, still preferably 1 to 8, and particularly preferably 1 to 4. Specific examples thereof include a methoxy group, ethoxy group, propoxy group, butoxy group, pentyloxy group, hexyloxy group, heptyloxy group, octyloxy group, nonyloxy group, decyloxy group, undecyloxy group, dodecyloxy group, tridecyloxy group, tetradecyloxy group, pentadecyloxy group, and the like.

Acyl groups in $R^{1A}$ may be each independently straight chain, branched chain, or cyclic. A cyclic acyl group may be comprised of only a cyclic structure, or may have a structure in which a chain alkyl group and/or chain acyl group is further bound to the cyclic structure. The number of carbon atoms in acryl is preferably 1 to 15, still preferably 1 to 8, and particularly preferably 1 to 4. Specific examples thereof include an acetyl group, propionyl group, butanoyl group, pentanoyl group, hexanoyl group, heptanoyl group, octanoyl group, nonanoyl group, decanoyl group, undecanoyl group, dodecanoyl group, tridecanoyl group, tetradecanoyl group, pentadecenoyl group, and the like.

In one preferred embodiment, $R^{1A}$ is a hydrogen atom.

$M^1$ and $M^2$ may be the same or different from each other. In one preferred embodiment, $M^1$ and $M^2$ are the same. $M^{1c}$ and $M^{2c}$ may be the same or different from each other. In one preferred embodiment, $M^{1c}$ and $M^{2c}$ are the same.

In general formula (A), an alkyl group in $M^1$, $M^2$, $M^{1c}$ and $M^{2c}$ may be straight chain or branched chain, and the number of carbon atoms is preferably 1 to 12, still preferably 1 to 8, and particularly preferably 1 to 5. In a still preferred embodiment, the number of carbon atoms in an alkyl group is 2. A polythiophene compound having excellent electrical conductivity is obtained if the number of carbon atoms in an alkyl group is within a preferred range. Specific examples thereof include a methyl group, ethyl group, propyl group, butyl group, pentyl group, hexyl group, heptyl group, octyl group, nonyl group, decyl group, undecyl group, dodecyl group, tridecyl group, tetradecyl group, pentadecyl group, and the like.

Examples of an alkali metal in $M^1$, $M^2$, $M^{1c}$ and $M^{2c}$ in above-described general formula (A) include lithium, sodium, potassium, rubidium, cesium, and the like. An alkali metal is preferably sodium or potassium from the viewpoint of availability and operability of raw material metal compounds.

Examples of an alkaline earth metal in $M^1$, $M^2$, $M^{1c}$ and $M^{2c}$ in above-described general formula (A) include beryllium, magnesium, calcium, strontium, barium, radium, and the like. An alkaline earth metal is preferably magnesium or potassium from the viewpoint of availability and operability of raw material metal compounds. However, if one of $M^1$ and $M^2$ is an alkaline earth metal, then the compound has a structure in which the alkaline earth metal atom is bound to two $O^-$ in one phosphoric acid or phosphonic acid moiety and the other of $M^1$ and $M^2$ is not present, or the compound has a structure in which the alkaline earth metal atom crosslinks $O^-$ of two phosphoric acid or phosphonic acid moieties.

In other wors, the compound has a structure in which a crosslink occurs within a molecule, or the compound has a structure in which two molecules are crosslinked. In addition, if one of $M^{1c}$ and $M^{2c}$ is an alkaline earth metal, then the compound has a structure in which the alkaline earth metal atom is bound to two $O^-$ in one phosphoric acid or phosphonic acid moiety and the other of $M^{1c}$ and $M^{2c}$ is not present, or the compound has a structure in which the alkaline earth metal atom crosslinks $O^-$ of two phosphoric acid or phosphonic acid moieties. In other words, the compound has a structure in which a crosslink occurs within a molecule, or the compound has a structure in which two molecules are crosslinked.

If at least one of $M^1$, $M^2$, $M^{1c}$ and $M^{2c}$ is a hydrogen atom, then a polythiophene compound may be bound to a basic substance at a moiety of the hydrogen atom to form a salt. The basic substance may be a basic compound or may be a basic ion. Examples of the basic substance include organic compounds having basic nitrogen. In the case of an organic compound having basic nitrogen, an oxygen atom having a negative charge at a phosphoric acid or phosphonic acid moiety of a polythiophene compound forms an ionic bond at a moiety of the basic nitrogen to form a salt. Examples of basic nitrogen include organic amine compounds. The organic amine may be an aliphatic amine, may be an aromatic amine, or may be a nitrogen-containing aromatic compound. The aliphatic amine may be a primary amine, may be a secondary amine, may be a tertiary amine, or may be quaternary ammonium. The number of carbon atoms of an alkyl group of aliphatic alkylamine is preferably 1 to 12, more preferably 1 to 6, and still preferably 1 to 4. Examples of primary amine include monoalkylamine. Examples of secondary amine include dialkylamine. Examples of tertiary amine include trialkylamine. Additional specific examples thereof include trimethylamine, triethylamine, and tributylamine. Examples of quaternary amine include tetraalkylammonium salt. An alkyl chain may comprise a hydroxyl group. Examples thereof include dimethylaminoethanol. Examples of aromatic amine include aniline, toluidine, and xylidine. Examples of nitrogen-containing aromatic compound include pyridine, picoline, lutidine, collidine, imidazole, and 4-dimethylaminopyridine. Guanidine may also be used.

In the above-described general formula (A), both $M^1$ and $M^2$ may be an alkyl group, but it is preferable that at least one is a hydrogen atom, an alkali metal, an alkaline earth metal, or organic amine from the viewpoint of electrical conductivity. More preferably, at least one is a hydrogen atom, and particularly preferably, both are hydrogen atoms. Further, both $M^{1c}$ and $M^{2c}$ may be an alkyl group, but it is preferable that at least one is a hydrogen atom, an alkali metal, an alkaline earth metal, or organic amine from the viewpoint of electrical conductivity. More preferably, at least one is a hydrogen atom, and particularly preferably, both are hydrogen atoms.

Specific examples of a structural unit of the above-described general formula (A) include the following formulas (9), (10), (11), (13), and the like.

[Chemical Formula 9]

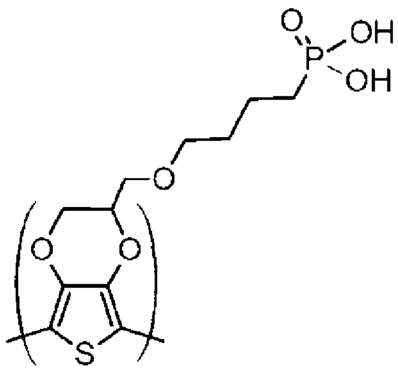

(9)

[Chemical Formula 10]

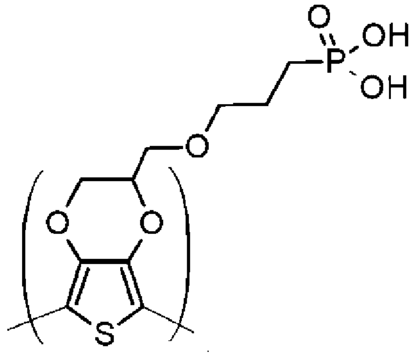

(10)

[Chemical Formula 11]

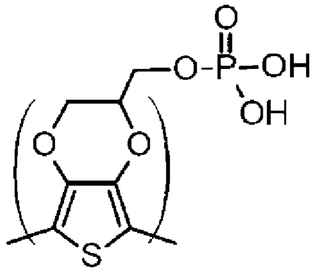

(11)

[Chemical Formula 13]

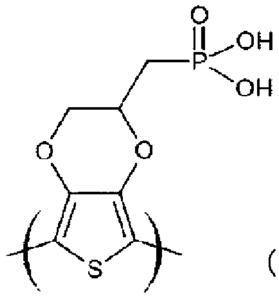

(13)

In one embodiment, a structural unit of the polythiophene compound of the present invention may be comprised of only a structural unit of the above-described general formula (A). In one embodiment, the polythiophene compound of the present invention is substantially free of a structural unit other than the structural unit of the above-described general formula (A). An advantageous property can be exerted at a high level if structural units of a polymer are comprised of only the structural unit of the above-described general formula (A).

In another embodiment, the polythiophene compound of the present invention may comprise a structural unit other than the structural unit of the above-described general formula (A) to the extent that the effect of the present invention is not inhibited.

However, if the content of structural units other than general formula (A) is too high, then the advantage of the present invention would be compromised. Thus, it is preferable that the content of structural units other than general formula (A) is not too high. The content of structural units other than general formula (A) is preferably 40 mol% or less, more preferably 30 mol% or less, still preferably 20 mol% or less, even more preferably 10 mol% or less, especially preferably 5 mol% or less, particularly preferably 3 mol% or less, and most preferably 1 mol% or less, with respect to the total structural units in a polythiophene compound. Further, the content can also be 0.1 mol% or less or can be 0.01 mol% or less.

An electrically conductive polythiophene compound having a self-doping property needs to have a hydrogen ion donating phosphoric acid or phosphonic acid moiety. A hydrogen ion donating phosphoric acid or phosphonic acid moiety refers to a phosphoric acid or phosphonic acid moiety in which there is at least one -P-OH group. Any number

can be selected as the number of phosphorous-containing thiophene monomer residues comprising a hydrogen ion donating phosphoric acid or phosphonic acid moiety in the polythiophene compound of the present invention. The ratio of phosphorous-containing thiophene monomer residues comprising a hydrogen ion donating phosphoric acid or phosphonic acid moiety can be selected from, for example, 10% or greater, 20% or greater, 30% or greater, 40% or greater, 50% or greater, 60% or greater, 70% or greater, 80% or greater, 90% or greater, or 95% or greater, when the total number of phosphorous-containing thiophene monomer residues which are present in the polythiophene compound is 100%. Alternatively, the ratio may be 100%. Further, when it is desirable to control the hydrogen ion donating group (-P-OH) content for some reason, a design can be implemented to control the number of hydrogen ion donating phosphoric acid or phosphonic acid moieties. In such a case, the ratio of phosphorous-containing thiophene monomer residues comprising a hydrogen ion donating phosphoric acid or phosphonic acid moiety can be designed to be, for example, 95% or less, 90% or less, 85% or less, 80% or less, 75% or less, or 70% or less, when the total number of phosphorous-containing thiophene monomer residues which are present in the polythiophene compound of the present invention is 100%.

Further, the ratio of hydrogen ion donating phosphoric acid or phosphonic acid moieties to the total number of phosphoric acid or phosphonic acid moieties can be designed to be any ratio. The ratio of hydrogen ion donating phosphoric acid or phosphonic acid moieties can be selected from, for example, 10% or greater, 20% or greater, 30% or greater, 40% or greater, 50% or greater, 60% or greater, 70% or greater, 80% or greater, 90% or greater, or 95% or greater, when the total number of phosphoric acid or phosphonic acid moieties which are present in the polythiophene compound of the present invention is 100%. Alternatively, the ratio can be 100%. Further, when it is desirable to control the hydrogen ion donating group content for some reason, a design can be implemented to control the number of hydrogen ion donating phosphoric acid or phosphonic acid moieties. In such a case, the ratio of hydrogen ion donating phosphoric acid or phosphonic acid moieties can be designed to be, for example, 95% or less, 90% or less, 85% or less, 80% or less, 75% or less, or 70% or less, when the total number of phosphoric acid or phosphonic acid moieties which are present in the polythiophene compound of the present invention is 100%.

The aforementioned ratio of hydrogen ion donating phosphoric acid or phosphonic acid moieties can be controlled by, for example, adjusting the type and amount of a thiophene compound used for the manufacture of a polythiophene compound.

The polythiophene compound of the present invention can be manufactured by using the method described below.

(Molecular weight)

The molecular weight of the polythiophene compound of the present invention is not particularly limited. The weight average molecular weight of the polythiophene compound of the present invention is preferably 1,000 or greater, and more preferably 2,000 or greater. The weight average molecular weight of the polythiophene compound of the present invention is preferably 500,000 or less, more preferably 200,000 or less, and still preferably 100,000 or less.

The polythiophene compound of the present invention preferably comprises a monomer residue having a phosphoric acid or phosphonic acid structural moiety [$-OP(O)(OH)_2$ or - $P(O)(OH)_2$], monoalkyl phosphate ester or monoalkyl phosphonate ester structural moiety [-OP(O)(OH)(OR) or -P(O)(OH)(OR), wherein R is an alkyl group in which the number of carbon atoms is 1 to 15], or monohydrogen phosphate or monohydrogen phosphonate structural moiety [$-OP(O)(OH)(OM^6)$ or - $P(O)(OH)(OM^6)$, wherein $M^6$ is an alkali metal, an alkaline earth metal, or an ammonium group]. A phosphoric acid or phosphonic acid structural moiety, monoalkyl phosphate ester or monoalkyl phosphonate ester structural moiety, or monohydrogen phosphate or monohydrogen phosphonate structural moiety can perform doping to a thiophene ring of the polythiophene compound main chain by a hydrogen ion released from a hydrogen ion donating group (-P-OH) thereof.

It should be noted that in the present specification, a monohydrogen phosphate or phosphonate structural moiety refers to a moiety having a structure of monohydrogen phosphate or monohydrogen phosphonate. Specifically, this refers to a moiety where only one of two hydrogen atoms of a phosphoric acid or phosphonic acid structural moiety is replaced with a metal atom or the like to form a salt, and the other hydrogen remains as is.

[Thiophene compound]

A phosphorous-containing thiophene compound is used as a monomer to manufacture a polythiophene compound in the method of the present invention.

[Phosphorous-containing thiophene compound]

A phosphorous-containing thiophene compound is a compound represented by the following general formula

(Am):

[Chemical Formula 2A]

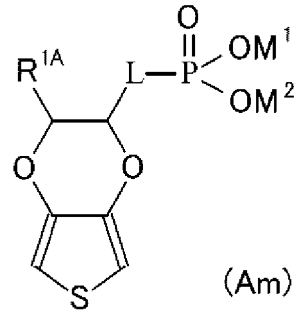

(Am)

In the above-described general formula (Am), L is represented by formula (21):

[Chemical Formula 21]

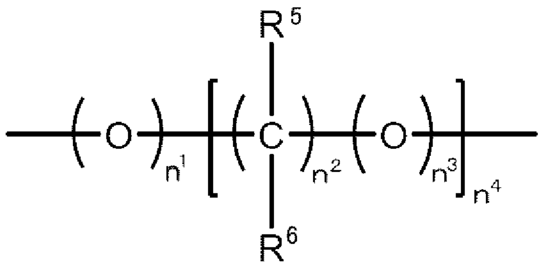

(21)

wherein $R^5$ is independently a hydrogen atom or a straight chain or branched chain alkyl group in which the number of carbon atoms is 1 to 5, $R^6$ is independently a hydrogen atom or a straight chain or branched chain alkyl group in which the number of carbon atoms is 1 to 5, $n^1$ is 0 or 1, $n^2$ is independently an integer from 1 to 6, $n^3$ is independently 0 or 1, $n^4$ is an integer from 0 to 12, and the left end of formula (21) is bound to the carbon atom in the dioxane ring in formula (Am).

In one embodiment, L is $-(CH_2)_n-$, wherein n is 0 to 12.

$M^1$ and $M^2$ are each independently an alkyl group in which the number of carbon atoms is 1 to 15, a hydrogen atom, an alkali metal, an alkaline earth metal, or an ammonium group, with the proviso that if one of $M^1$ and $M^2$ is an alkaline earth metal, then the compound has a structure in which the alkaline earth metal atom is bound to two $O^-$ in one phosphoric acid or phosphonic acid moiety and the other of $M^1$ and $M^2$ is not present, or the compound has a structure in which the alkaline earth metal atom crosslinks $O^-$ of two phosphoric acid or phosphonic acid moieties.

$R^{1A}$ is a hydrogen atom, an alkyl group, an alkoxy group, an acyl group, or a group represented by formula (15):

[Chemical Formula 15]

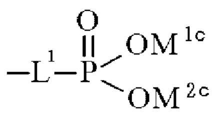

(15)

$L^1$ is represented by formula (22):

[Chemical Formula 22]

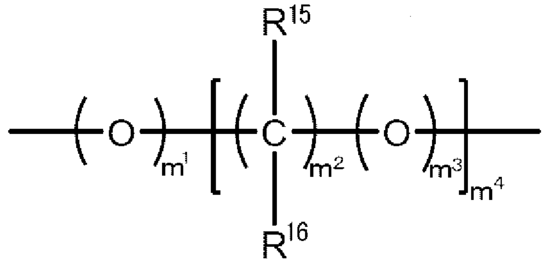

(22)

wherein $R^{15}$ is independently a hydrogen atom or a straight chain or branched chain alkyl group in which the number of carbon atoms is 1 to 5, $R^{16}$ is independently a hydrogen atom or a straight chain or branched chain alkyl group in which the number of carbon atoms is 1 to 5, $m^1$ is 0 or 1, $m^2$ is independently an integer from 1 to 6, $m^3$ is independently 0 or 1, $m^4$ is an integer from 0 to 12, and the left end of formula (22) is bound to the carbon atom in the dioxane ring in formula (Am).

In this regard, $M^{1c}$ and $M^{2c}$ are each independently an alkyl group in which the number of carbon atoms is 1 to 15, a hydrogen atom, an alkali metal, an alkaline earth metal, or an ammonium group, with the proviso that if one of $M^{1c}$ or $M^{2c}$ is an alkaline earth metal, then the compound has a structure in which the alkaline earth metal atom is bound to two $O^-$ in one phosphoric acid or phosphonic acid moiety and the other of $M^{1c}$ and $M^{2c}$ is not present, or the compound has a structure in which the alkaline earth metal atom crosslinks $O^-$ of two phosphoric acid or phosphonic acid moieties.

If at least one of $M^1$, $M^2$, $M^{1c}$ and $M^{2c}$ is a hydrogen atom, then a polythiophene compound may be bound to a basic substance at a moiety of the hydrogen atom to form a salt. The basic substance may be a basic compound or may be a basic ion. Examples of the basic substance include organic compounds having basic nitrogen. In the case of an organic compound having basic nitrogen, an oxygen atom having a negative charge at a phosphoric acid or phosphonic acid moiety of a polythiophene compound forms an ionic bond at a moiety of the basic nitrogen to form a salt. Examples of basic nitrogen include organic amine compounds. The organic amine may be an aliphatic amine, may be an aromatic amine, or may be a nitrogen-containing aromatic compound. The aliphatic amine may be a primary amine, may be a secondary amine, may be a tertiary amine, or may be quaternary ammonium. The number of carbon atoms of an alkyl group of aliphatic alkylamine is preferably 1 to 12, more preferably 1 to 6, and still preferably 1 to 4. Examples of primary amine include monoalkylamine. Examples of secondary amine include dialkylamine. Examples of tertiary amine include trialkylamine. Additional specific examples thereof include trimethylamine, triethylamine, and tributylamine. Examples of quaternary amine include tetraalkylammonium salt. An alkyl chain may comprise a hydroxyl group. Example thereof includes dimethylaminoethanol. Examples of aromatic amine include aniline, toluidine, and xylidine. Examples of nitrogen-containing aromatic compound include pyridine, picoline, lutidine, collidine, imidazole, and 4-dimethylaminopyridine. Guanidine may also be used.

An alkyl group in above-described $M^1$, $M^2$, $M^{1c}$ and $M^{2c}$ may be a straight chain alkyl group or a branched chain alkyl group. The number of carbon atoms is preferably 1 to 12, still preferably 1 to 8, and particularly preferably 1 to 5. The number of carbon atoms is most preferably 2. Specific examples thereof include a methyl group, ethyl group, propyl group, butyl group, pentyl group, hexyl group, heptyl group, octyl group, nonyl group, decyl group, undecyl group, dodecyl group, tridecyl group, tetradecyl group, pentadecyl group, and the like. Within the scope described above, progression of an oxidative polymerization reaction may be smooth to facilitate the polythiophene compound of the present invention to be obtained.

Examples of an alkali metal in above-described $M^1$, $M^2$, $M^{1c}$ and $M^{2c}$ include lithium, sodium, potassium, rubidium, cesium, and the like. An alkali metal is preferably sodium or potassium from the viewpoint of availability and operability of raw material metal compounds.

Examples of an alkaline earth metal in above-described $M^1$, $M^2$, $M^{1c}$ and $M^{2c}$ include beryllium, magnesium, calcium, strontium, barium, radium, and the like. An alkaline earth metal is preferably magnesium or calcium from the viewpoint of availability and operability of raw material metal compounds, with the proviso that if one of $M^1$ and $M^2$ is an alkaline earth metal, then the compound has a structure in which the alkaline earth metal atom is bound to two $O^-$ in one phosphoric acid or phosphonic acid moiety and the other of $M^1$ and $M^2$ is not present, or the compound has a structure in which the alkaline earth metal atom crosslinks $O^-$ of two phosphoric acid or phosphonic acid moieties. In other words, the compound has a structure in which a crosslink is formed within a molecule, or the compound forms a structure in which two molecules are crosslinked. If one of $M^{1c}$ and $M^{2c}$ is an alkaline earth metal, then the compound has a structure in which the alkaline earth metal atom is bound to two $O^-$ in one phosphoric acid or phosphonic acid moiety and the other of $M^{1c}$ and $M^{2c}$ is not present, or the compound has a structure in which the alkaline earth metal atom crosslinks $O^-$ of two phosphoric acid or phosphonic acid moieties. In other wors, the compound has a structure in which a crosslink

is formed within a molecule, or the compound has a structure in which two molecules are crosslinked.

In one embodiment, $M^1$ and $M^2$ are hydrogen atoms. If $M^1$ and $M^2$ are hydrogen atoms, then there is an advantage in that the manufacture of a polythiophene compound comprising a diacid form is facilitated. In polythiophene, a diacid form generally has higher electrical conductivity than a dialkyl form and a monoacid form. Therefore, it is advantageous that a polythiophene compound comprising a diacid form can be readily manufactured.

Further, in one embodiment, $M^{1c}$ and $M^{2c}$ are hydrogen atoms. If $M^{1c}$ and $M^{2c}$ are hydrogen atoms, then there is an advantage in that the manufacture of a polythiophene compound comprising a diacid form is facilitated.

$M^1$ and $M^2$ may be the same or different from each other. In one preferred embodiment, $M^1$ and $M^2$ are the same. $M^{1c}$ and $M^{2c}$ also may be the same or may be different from each other. In one preferred embodiment, $M^{1c}$ and $M^{2c}$ are the same.

If $M^1$ and $M^2$ are both alkyl, then a polythiophene compound having excellent electrical conductively may be obtained by hydrolyzing a compound obtained from oxidative polymerization of a monomer mixture comprising the thiophene compound described above.

Likewise, if $M^{1c}$ and $M^{2c}$ are both alkyl, then a polythiophene compound having excellent electrical conductively may be obtained by hydrolyzing a compound obtained from oxidative polymerization of a monomer mixture comprising the thiophene compound described above.

Alkyl groups in $R^{1A}$ may be straight chain, branched chain, or cyclic. A cyclic alkyl group may be comprised of only a cyclic structure, or may have a structure in which a chain alkyl group is further bound to the cyclic structure. The number of carbon atoms in an alkyl group is preferably 1 to 15, still preferably 1 to 8, and particularly preferably 1 to 4. Specific examples thereof include a methyl group, ethyl group, propyl group, butyl group, pentyl group, hexyl group, heptyl group, octyl group, nonyl group, decyl group, undecyl group, dodecyl group, tridecyl group, tetradecyl group, pentadecyl group, and the like.

Alkoxy groups in $R^{1A}$ may be straight chain, branched chain, or cyclic. A cyclic alkoxy group may be comprised of only a cyclic structure, or may have a structure in which a chain alkyl group and/or chain alkoxy group is further bound to the cyclic structure. The number of carbon atoms in an alkoxy group is preferably 1 to 15, still preferably 1 to 8, and particularly preferably 1 to 4. Specific examples thereof include a methoxy group, ethoxy group, propoxy group, butoxy group, pentyloxy group, hexyloxy group, heptyloxy group, octyloxy group, nonyloxy group, decyloxy group, undecyloxy group, dodecyloxy group, tridecyloxy group, tetradecyloxy group, pentadecyloxy group, and the like.

Acyl groups in $R^{1A}$ may be straight chain, branched chain, or cyclic. A cyclic acyl group may be comprised of only a cyclic structure, or may have a structure in which a chain alkyl group and/or chain acyl group is further bound to the cyclic structure. The number of carbon atoms in acryl is preferably 1 to 15, still preferably 1 to 8, and particularly preferably 1 to 4. Specific examples thereof include an acetyl group, propionyl group, butanoyl group, pentanoyl group, hexanoyl group, heptanoyl group, octanoyl group, nonanoyl group, decanoyl group, undecanoyl group, dodecanoyl group, tridecanoyl group, tetradecanoyl group, pentadecenoyl group, and the like.

In one preferred embodiment, $R^{1A}$ is an alkyl group or a hydrogen atom, and still preferably a hydrogen atom.

Specific examples of above-described general formula (Am) include the following formulas (5), (9B), (10B), (11C), and the like.

[Chemical Formula 5]

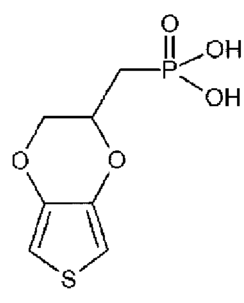

(5)

[Chemical Formula 9B]

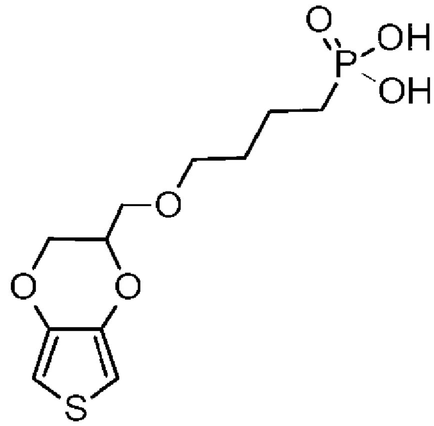

(9 B)

[Chemical Formula 10B]

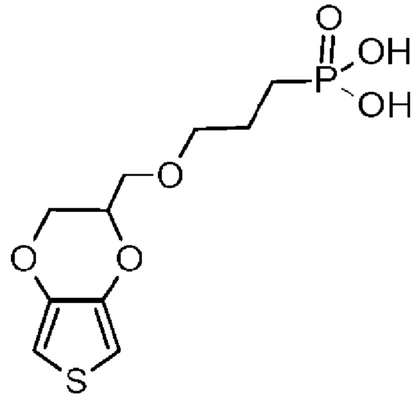

(1 0 B)

[Chemical Formula 11C]

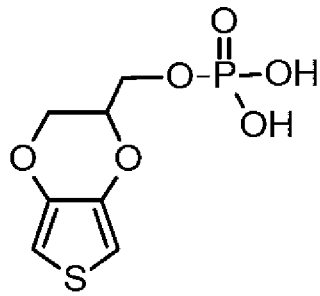

(1 1 C)

[Method of manufacturing a phosphorous-containing thiophene compound]

A phosphorous-containing thiophene compound used in the present invention can be manufactured, for example, by the following method when $R^{1A}$ is a hydrogen atom. In particular, the compound is preferably manufactured by the following first step and second step from the viewpoint of yield and operability.

(First step)

In the first step, a compound represented by the following general formula (3) is obtained by a known method.

[Chemical Formula 3]

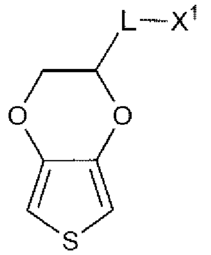

(3)

In formula (3), L is represented by formula (21):

[Chemical Formula 21]

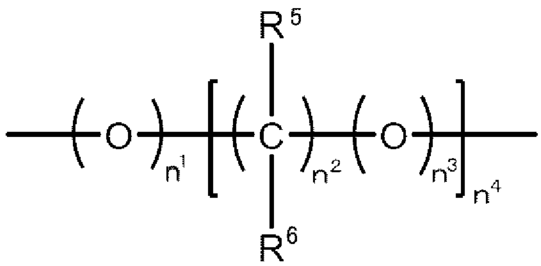

(21)

wherein $R^5$ is independently a hydrogen atom or a straight chain or branched chain alkyl group in which the number of carbon atoms is 1 to 5, $R^6$ is independently a hydrogen atom or a straight chain or branched chain alkyl group in which the number of carbon atoms is 1 to 5, $n^1$ is 0 or 1, $n^2$ is independently an integer from 1 to 6, $n^3$ is independently 0 or 1, $n^4$ is an integer from 0 to 12, and the left end of formula (21) is bound to the carbon atom in the dioxane ring in formula (3).

In one embodiment, L is $-(CH_2)_n-$, wherein n is 0 to 12. n is preferably 0 to 4, more preferably 0 to 2, and particularly preferably 1. $X^1$ is a halogen atom, such as a fluorine atom, a chlorine atom, a bromine atom, or an iodine atom. A chlorine atom or a bromine atom is preferable in view of the availability and operability of raw material.

Specifically, a compound wherein L is $-(CH_2)_n-$ in above-described formula (3) can be obtained by, for example, the method described in Japanese Laid-Open Publication No. 2014-74007.

In addition, an embodiment of n = 1, i.e., a compound represented by the following general formula (3A), can be obtained by a method of heating 3-halogenated-1,2-propanediol and 3,4-dimethoxythioiphene in the presence of an acidic catalyst.

[Chemical Formula 3A]

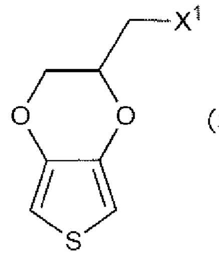

(3A)

Examples of the above-described acidic catalyst include sulfuric acid, para-toluenesulfonic acid monohydrate, methanesulfonic acid, and the like. The acidic catalyst is preferably para-toluenesulfonic acid monohydrate.

A compound wherein L is not $-(CH_2)_n-$ in the above-described formula (3) can also be obtained by a method similar to the method described above.

(Reaction temperature)

The above-described heating is performed for progressing the reaction. The heating temperature is not particularly limited, as long as a reaction progresses at a suitable rate, but is preferably 60°C or higher, still preferably 70°C

or higher, and particularly preferably 80°C or higher. The temperature is preferably 200°C or lower, still preferably 150°C or lower, and particularly preferably 120°C or lower.

(Reaction period of time)

The period of time of the heating described above is not particularly limited. A sufficient period of time for a starting material to react may be appropriately selected under each condition. If a reaction progresses sufficiently, then a difference in reaction period of time would not significantly affect the effect of the present invention. For example, the reaction period of time is preferably 6 hours or more, and more preferably 12 hours or more. The reaction period of time is preferably 3 days or less, and more preferably 2 days or less.

(Solvent)

A solvent may be used as needed in the first step. A solvent is not particularly limited, as long as the solvent is not reactive in an oxidative polymerization reaction. Examples thereof include: aromatic hydrocarbons such as benzene, toluene, xylene, and mesitylene; aliphatic hydrocarbons such as n-hexane, cyclohexane, n-octane, and n-decane; halogenated hydrocarbons such as dichloromethane, dichloroethane, chloroform, carbon tetrachloride, chlorobenzene, and o-dichlorobenzene; ethers such as tetrahydrofuran, diethyl ether, t-butyl methyl ether, dimethoxyethane, dioxane, and diethylene glycol dimethyl ether; and the like. A solvent is preferably xylene, toluene, or diethylene glycol dimethyl ether, and still preferably xylene or toluene.

(Purification)

A product obtained in the first step may be used in the second step without performing a post-process such as purification. Further, a purified product obtained by purifying the product obtained in the first step by a known method may be used in the second step as needed.

(Second step)

In the second step, a compound represented by the above-described general formula (3) is reacted with tris(trialkylsilyl)phosphite or trialkylphosphite to replace $X^1$ in the compound represented by general formula (3) with a bis(trialkylsilyl)phosphonate moiety or phosphonate diester moiety. When synthesizing thiophene comprising a phosphonic acid moiety, i.e., a diacid form, a method using tris(trialkylsilyl)phosphite is preferable in terms of the efficiency of a reaction, and the like.

Tris(trialkylsilyl)phosphite is represented by the following general formula (11A):

[Chemical Formula 11A]

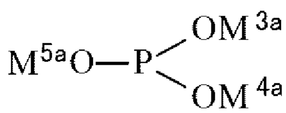

(11A)

wherein $M^{3a}$, $M^{4a}$, and $M^{5a}$ are each independently trimethylsilyl, triethylsilyl, tert-butyldimethylsilyl, or triisopropylsilyl, preferably trimethylsilyl or triethylsilyl, and still preferably trimethylsilyl. $M^{3a}$, $M^{4a}$, and $M^{5a}$ may be independently selected, but are preferably the same. Specific examples thereof include tris(trimethylsilyl)phosphite, tris(triethylsilyl)phosphite, and the like.

For example, heating a mixture of a compound represented by the above-described general formula (3) and tris(trialkylsilyl)phosphite causes a Michaelis-Arbuzov rearrangement reaction to occur. A compound of general formula (2A) is obtained as a rearranged product thereof.

[Chemical Formula 2A]

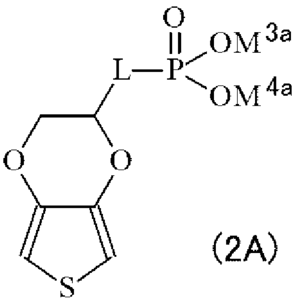

(2A)

In the formula, $M^{3a}$ and $M^{4a}$ are each independently trimethylsilyl, triethylsilyl, tert-butyldimethylsilyl, or triisopropylsilyl, which are generally used as a protecting group of a hydroxyl group. A compound of the following general formula (2C) can be obtained by performing deprotection by a known method.

For example, a basic aqueous solution such as an aqueous solution of sodium carbonate, potassium carbonate, or ammonia is allowed to act on a compound of the above-described general formula (2A), and thereby deprotection occurs.

[Chemical Formula 2C]

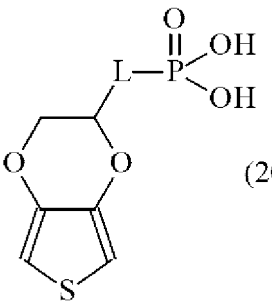

(2C)

While the compound of the above-described general formula (2C) can be obtained by hydrolyzing general formula (2B) described below by a known method, the compound can be relatively readily obtained by a method using the tris(trialkylsilyl)phosphite described above.

Trialkylphosphite is represented by the following general formula (11B):

[Chemical Formula 11B]

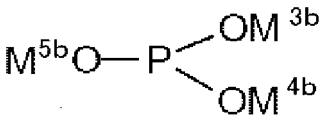

(11B)

wherein $M^{3b}$, $M^{4b}$, and $M^{5b}$ are each independently alkyl in which the number of carbon atoms is 1 to 15. The number of carbon atoms is preferably 1 to 12, still preferably 1 to 8, and particularly preferably 1 to 5. In a still preferred embodiment, the number of carbon atoms of an alkyl group is 2. $M^{3b}$ and $M^{4b}$ are the same as $M^1$ and $M^2$ in general formula (Am), respectively. $M^{3b}$ and $M^{4b}$ are selected in accordance with $M^1$ and $M^2$ of interest in the compound of general formula (Am). $M^{3b}$ and $M^{4b}$ may be the same or may be different. While $M^{5b}$ may be independently selected from $M^1$ and $M^2$ of interest in the compound of general formula (Am), it is preferable that $M^{5b}$ is the same as either $M^{3b}$ or $M^{4b}$. In one preferred embodiment, $M^{3b}$, $M^{4b}$, and $M^{5b}$ are the same. Specific examples thereof include trimethylphosphite, triethylphosphite, and the like.

For example, heating a mixture of the compound represented by the above-described general formula (3) and trialkylphosphite causes a Michaelis-Arbuzov rearrangement reaction to occur. A compound of general formula (2B) is obtained as a rearranged product thereof.

[Chemical Formula 2B]

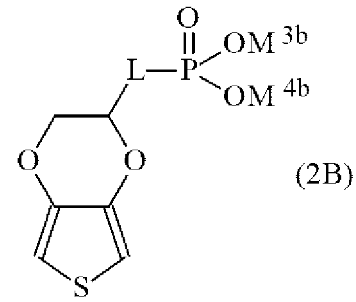

(2B)

In the formula, $M^{3b}$ and $M^{4b}$ are each independently alkyl in which the number of carbon atoms is 1 to 15.

The mixing ratio (molar ratio) of the compound represented by general formula (3) and trialkylphosphite or tris(trialkylsilyl)phosphite is not particularly limited. However, from the viewpoint of yield, and the like, the mixing ratio (molar ratio) of the compound represented by general formula (3) and trialkylphosphite or tris(trialkylsilyl)phosphite is preferably 0.8 mole or greater and more preferably 1 mole or greater of trialkylphosphite or tris(trialkylsilyl)phosphite with respect to 1 mole of the compound represented by general formula (3). Further, trialkylphosphite or tris(trialkylsilyl)phosphite is preferably 10 mole or less, still preferably 5 mole or less, and particularly preferably 3 mole or less with respect to 1 mole of the compound represented by general formula (3).

(Reaction temperature)

The heating described above is performed for progressing a reaction. The temperature at the time of a reaction is not particularly limited, as long as a reaction progresses at a suitable rate, but is preferably 100°C or higher, still preferably 110°C or higher, and particularly preferably 120°C or higher. Further, the temperature is preferably 220°C or lower, still preferably 200°C or lower, and particularly preferably 160°C or lower.

(Reaction period of time)

The period of time of the heating described above is not particularly limited. A sufficient period of time for a reaction material to react under conditions such as a temperature may be appropriately selected. If a reaction progresses sufficiently, then a difference in reaction periods would not significantly affect the effect of the present invention. The reaction period of time is preferably 6 hours or more, and more preferably 12 hours or more. The reaction period of time is preferably 3 days or less, and more preferably 2 days or less.

(Solvent)

A solvent may be used as needed in the second step. A solvent is not particularly limited, as long as the solvent is a liquid that is not reactive in the second step and is capable of dissolving or dispersing a reaction material as a solvent. Examples thereof include: aromatic hydrocarbons such as benzene, toluene, xylene, and mesitylene; aliphatic hydrocarbons such as n-hexane, cyclohexane, n-octane, and n-decane; halogenated hydrocarbons such as dichloromethane, dichloroethane, chloroform, carbon tetrachloride, chlorobenzene, and o-dichlorobenzene; ethers such as tetrahydrofuran, diethyl ether, t-butyl methyl ether, dimethoxyethane, dioxane, and diethylene glycol dimethyl ether; and the like. A solvent is preferably toluene, xylene, or diethylene glycol dimethyl ether, and still preferably xylene or toluene.

(Hydrolysis)

A compound of general formula (2B) obtained through the reaction described above may be subjected to hydrolysis or ion exchange as needed.

For example, a compound of general formula (2B) obtained through the reaction described above may be subjected to hydrolysis as needed. A compound of general formula (2B) may be subjected to hydrolysis and then additionally subjected to ion exchange. A compound wherein $M^{3b}$ and $M^{4b}$ are a hydrogen atom, an alkali metal, or the like in general formula (2B) can be obtained by performing hydrolysis of a compound of general formula (2B). Further, the type of $M^{3b}$ and $M^{4b}$ can be converted to a desired type by further performing ion exchange.

Various known methods can be used as a method of hydrolysis. The methods and conditions for the hydrolysis of a polythiophene compound described below can be used.

Various known methods can be used as a method of ion exchange. In addition, the methods and conditions for the ion exchange of a phosphorous-containing thiophene copolymer described below can be used.

(Purification)

A product obtained in the second step may be used in a polymerization step as a phosphorous-containing thiophene compound without performing a post-process such as purification. Alternatively, a post-process such as purification by a known method may be performed.

(Manufacturing method in the cases where $R^{1A}$ is other than a hydrogen atom)

A phosphorous-containing thiophene compound can be manufactured by a method that is basically similar to the method described above, even if $R^{1A}$ is other than a hydrogen atom.
If $R^{1A}$ is a group of formula (15), a phosphorous-containing thiophene compound can be manufactured by, for example, the following method.

(First step)

In the first step, a diol of general formula (17A) and 3,4-dialkoxythiophene of general formula (18) are reacted to obtain an intermediate represented by general formula (19A) through the following reaction.

[Chemical Formula 17A]

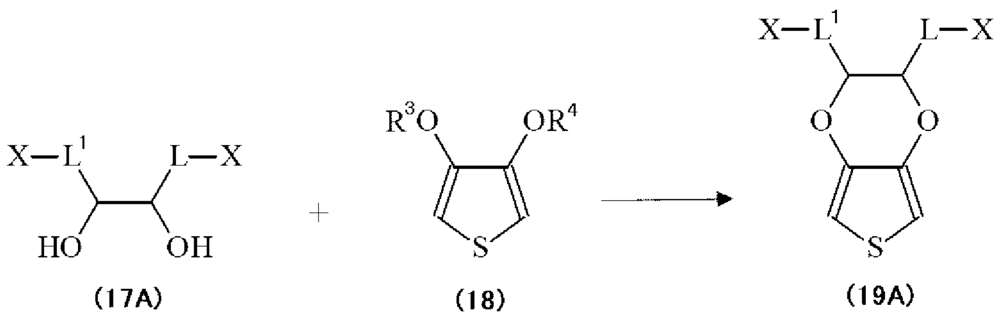

In the formula, $R^3$ and $R^4$ are alkyl groups (e.g., methyl group) .
If, for example, L and $L^1$ are $-(CH_2)-$, then 1,4-dihalogenated-2,3-butanediol is used as a compound of formula (17A) instead of 3-halogenated-1,2-propanediol described above.
A compound wherein L and $L^1$ are other than $-(CH_2)-$ in formula (19A) can be obtained by a method that is similar to the method described above.

(Second step)

A phosphorous-containing thiophene compound of general formula (Am) is obtained by reacting the intermediate of general formula (19A) obtained in the first step with a compound of general formula (11A) through the method described above and performing deprotection, or by reacting the intermediate of general formula (19A) with a compound of general formula (11B) through the method described above.

[Chemical Formula 2A]

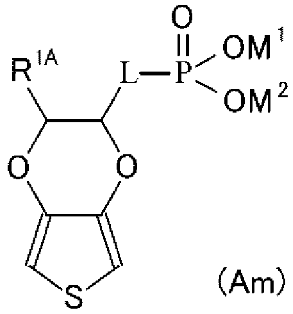

(Am)

In the formula, $R^{1A}$ is a group represented by formula (15):

[Chemical Formula 16]

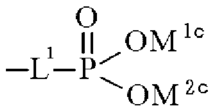

(15)

The mixing ratio of the intermediate and the phosphite is preferably 1.6 mole or greater and more preferably 2 mole or greater of phosphite to 1 mole of the intermediate. Further, the mixing ratio of the phosphite is preferably 20 mole or less, still preferably 10 mole or less, and particularly preferably 6 mole or less to 1 mole of the intermediate.

If $R^{1A}$ is a hydrogen atom, an alkyl group, an alkoxy group, or an acyl group, then a phosphorous-containing thiophene compound can be manufactured by, for example, the following method.

(First step)

In the first step, a diol of general formula (17B) and 3,4-dialkoxythiophene of general formula (18) are reacted to obtain an intermediate represented by general formula (19B) through the following reaction:

[Chemical Formula 17B]

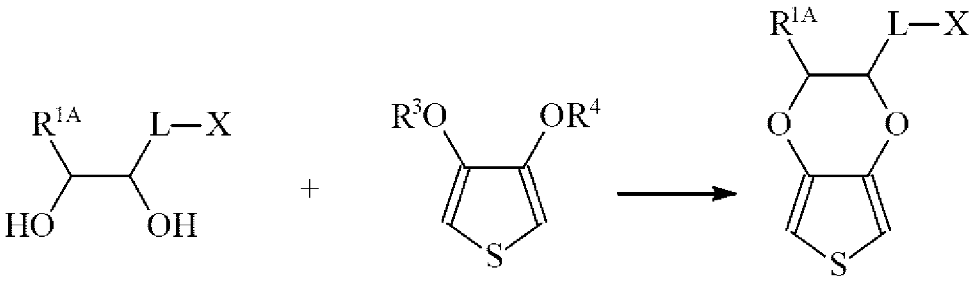

(17B) (18) (19B)

(Second step)

A phosphorous-containing thiophene compound of general formula (Am) is obtained by reacting the intermediate of general formula (19B) obtained in the first step with a compound of general formula (11A) through the method described above and performing deprotection, or by reacting the intermediate of general formula (19B) with a compound of general formula (11B) through the method described above.

[Chemical Formula 2A]

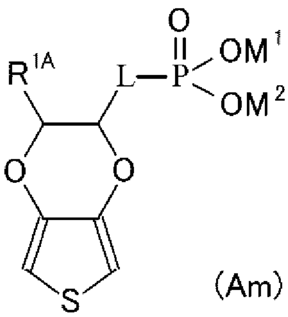

(Am)

In the formula, $R^{1A}$ is a hydrogen atom, an alkyl group, an alkoxy group, or an acyl group.

[Method of manufacturing a polythiophene compound]

The polythiophene compound of the present invention is obtained by subjecting the phosphorous-containing thiophene compound described above to oxidative polymerization by using a suitable oxidizing agent and performing a suitable purification step. A method that is conventional and known as an oxidative polymerization method for polymerizing a thiophene compound can be used as the method of oxidative polymerization. Manufacture under the conditions described below is preferable from the viewpoint of yield and operability.

It should be noted that in the present specification, "oxidative polymerization" refers to a reaction of polymerizing a thiophene monomer compound or thiophene monomer mixture by using an oxidizing agent to synthesize a polythiophene compound. In this regard, "oxidation" refers to removing hydrogen atoms at positions 2 and 5 from a thiophene monomer compound in the polymerization reaction. In the present specification, "oxidizing agent" refers to a reagent inducing such an oxidation reaction. An oxidative polymerization reaction of thiophene monomers is described in, for example, above-described Patent Documents 1 to 2, and the like. It should be noted that the term oxidative polymerization is described in Encyclopaedia Chimica as "A process where a compound having a hydrocarbon residue comprising a double bond contacts oxygen and is gradually polymerized; the best example is drying of oil and fat". However, polymerization of a thiophene monomer generally does not use oxygen in the air as an oxidizing agent. Thus, in this regard the term "oxidative polymerization" in the present specification has a slightly different meaning from the meaning used in the Encyclopaedia Chimica, and the like.

(Monomer)

A polythiophene compound comprising a structural unit of the above-described general formula (A) can be obtained by performing oxidative polymerization using the phosphorous-containing thiophene compound of the above-described general formula (Am) as a monomer for polymerization.

It should be noted that oxidative polymerization may be performed by using only one type of thiophene compound of general formula (Am) or may be performed by using two or more types of thiophene compounds of general formula (Am).

However, if the amount of a monomer other than that of general formula (Am) is too high, then the advantage of the present invention would be compromised. Thus, it is preferable that the amount of a monomer other than that of general formula (Am) is not too high. The amount of a monomer other than that of general formula (Am) is preferably 40 mol% or less, more preferably 30 mol% or less, still preferably 20 mol% or less, even more preferably 10 mol% or less, especially preferably 5 mol% or less, particularly preferably 3 mol% or less, and most preferably 1 mol% or less, with respect to the total amount of monomers used in the polymerization reaction.

(Oxidizing agent)

The oxidative polymerization reaction in the present invention is performed in the presence of an oxidizing agent. As the oxidizing agent, an oxidizing agent that is generally used for an oxidative polymerization reaction of a thiophene compound can be used. Specific examples thereof include ammonium persulfate, ferric chloride, ferric para-toluenesulfonate, ferric sulfate, ferric nitrate, and the like.

An oxidizing agent comprising an iron atom can be preferably used. More preferred examples include ferric chloride, ferric para-toluenesulfonate, ferric sulfate, and ferric nitrate.

Two or more types of the oxidizing agents described above may be used concomitantly. When using two or more types of the oxidizing agents concomitantly, it is preferable to use an oxidizing agent comprising an iron atom as one of the two or more types. Specifically, a preferred combination for concomitant use is a combination of ferric sulfate and ammonium persulfate.

The amount of oxidizing agent used is not particularly limited, as long as an oxidative polymerization reaction progresses satisfactorily. The amount is preferably 1 equivalent or more, still preferably 2 equivalents or more, and particularly preferably 3 equivalents or more with respect to a monomer used in an oxidative polymerization reaction. Further, the amount is preferably 100 equivalents or less, still preferably 60 equivalents or less, and particularly preferably 20 equivalents or less.

A reaction progresses smoothly if the amount used is within the range described above.

It should be noted that oxygen in the air generally would not be an oxidizing agent for polymerization of a thiophene monomer. Thus, even when a polymerization reaction is performed in the presence of air, oxygen in the air is generally not included in the amount of an oxidizing agent used in a polymerization reaction. In other words, the term "oxidative polymerization" is sometimes used to refer to a polymerization reaction using oxygen that is present in the air as an oxidizing agent, but the polymerization reactions in the present invention differ from such a polymerization reaction.

(Solvent)

The polymerization reaction of the present invention may use a solvent as needed.

A solvent is not particularly limited, as long as the solvent is a liquid that is capable of dissolving or dispersing a reaction material. Specific examples of the solvent include: water; aqueous solutions such as ammonium water, hydrochloric acid; alcohols such as methanol, ethanol, 1-propanol, 2-propanol; aromatic hydrocarbons such as benzene, toluene, xylene; ketones such as acetone, 2-butanone; halogenated hydrocarbons such as methylene chloride, chloroform, chlorobenzene; acetonitrile; dimethylacetamide; dimethylformamide; dimethyl sulfoxide; tetrahydrofuran; and the like. The solvent is preferably water, ammonia water, hydrochloric acid, methanol, ethanol, dimethylformamide, dimethyl sulfoxide, acetonitrile, acetone, tetrahydrofuran, or toluene, and still preferably water, methanol, acetonitrile, dimethylformamide, or dimethyl sulfoxide.

For the solvents described above, one type of solvent may be used alone, or two or more types may be mixed and used. A mixed solvent prepared by mixing two or more types of solvents is preferable.

(Reaction temperature)

The reaction temperature during polymerization is not particularly limited. The temperature is preferably -20°C or higher, more preferably 0°C or higher, still preferably 10°C or higher, and particularly preferably 20°C or higher. The temperature is also preferably 80°C or lower, and still preferably 60°C or lower.

(Reaction period of time)

For the reaction period of time of polymerization in the present invention, a period of time that is sufficient for a reaction under each condition may be appropriately selected. If a reaction progresses sufficiently, then a difference in reaction period of time would not significantly affect the effect of the present invention.

The reaction period of time is preferably 1 hour or more, more preferably 3 hours or more, still preferably 6 hours or more, even more preferably 9 hours or more, particularly preferably 12 hours or more, and if necessary it can be 15 hours or more, 18 hours or more, 21 hours or more, or 24 hours or more. Further, the reaction period of time is preferably 7 days or less, more preferably 5 days or less, still preferably 3 days or less, even more preferably 2 days or less, particularly preferably 36 hours or less, and if necessary it can be 30 hours or less, 28 hours or less, or 26 hours or less.

(Hydrolysis)

A polythiophene compound obtained through a polymerization reaction may be subjected to hydrolysis as needed. A phosphoric acid or phosphonic acid structural moiety [$-OP(O)(OH)_2$ or $-P(O)(OH)_2$], monoalkyl phosphate ester or monoalkyl phosphonate ester structural moiety [-OP(O)(OH)(OR) or -P(O)(OH)(OR), wherein R is an alkyl group in which the number of carbon atoms is 1 to 15], or monohydrogen phosphate or monohydrogen phosphonate structural moiety [$-OP(O)(OH)(OM^6)$ or $-P(O)(OH)(OM^6)$, wherein $M^6$ is an alkali metal, an alkaline earth metal, or an ammonium group] can be obtained by degrading an ester bond of an alkyl phosphate ester moiety or alkyl phosphonate ester moiety in the polythiophene compound by performing hydrolysis.

Hydrolysis can be performed through, for example, a method of treatment with a strong acid or a method of treatment with a strong alkali, or the like. For example, hydrolysis can be performed through a method of heating in an acidic aqueous solution or an alkaline aqueous solution, or the like. Examples of strong acid include protonic acids such as hydrochloric acid, sulfuric acid; Lewis acids such as trimethylsilyl bromide; and the like. Examples of strong alkali include potassium hydroxide, sodium hydroxide, and the like. In this regard, when a Lewis acid is used, for example, a method of reacting with a Lewis acid and then reacting with water, or the like can be preferably used. Alkali treatment

is preferable from the viewpoint of stability of a polythiophene compound main chain.

When heating is performed at the time of hydrolysis, the temperature is not particularly limited. The temperature is preferably 30°C or higher, and more preferably 50°C or higher. Further, the temperature is preferably 100°C or lower, and more preferably 90°C or lower.

The period of time of performing hydrolysis is not particularly limited. The period of time is preferably 1 hour or more, and more preferably 6 hours or more. Further, the period of time is preferably 4 days or less, and more preferably 2 days or less.

A polythiophene compound obtained be performing hydrolysis may be further subjected to ion exchange as needed to adjust the amount of hydrogen ion donating phosphoric acid or phosphonic acid structural moieties.

(Purification)

A polythiophene compound obtained from a polymerization reaction is subjected to a suitable purification operation. Any method known as a purification method of polythiophene compounds can be used as the purification operation. For example, an operation such as centrifugation, filtration, dehydration, drying, washing, ultrafiltration, or dialysis can be performed. The number and type of purification operations are not particularly limited. While a purification operation may be completed by performing one type of purification operation once, the purification operation may be performed twice or more as needed. For example, a purification operation may be performed three times or more, four times or more, or five times or more. In this regard, one type of purification operation may be repeated twice or more, or a plurality of types of purification operations may be combined to perform a purification operation twice or more times in total. While the number of times a purification operation is performed does not particularly have an upper limit, the number is preferably 20 times or less, more preferably 15 times or less, and still preferably 10 times or less. If the number is too high, then the entire manufacturing process would take a long period of time, so that the efficiency of manufacture would decrease.

In a preferred embodiment of the present invention, a chelate compound is used to perform purification. A resin having high electrical conductivity is obtained by performing purification using a chelate compound. In the present specification, a chelate compound refers to a compound having a plurality of ligands. As a method of purification using a chelate compound, any method that can contact a polythiophene compound with a chelate compound can be used. A method that can contact a polythiophene compound with a chelate compound in a liquid is preferred. In one embodiment, purification of a polythiophene compound can be performed by adding a solvent and a chelate compound to the polythiophene compound and stirring the mixture. A preferred solvent is water. The temperature at which purification is performed is not particularly limited. The temperature may be room temperature or a heated temperature. The temperature is preferably a temperature at which a mixture comprising a polythiophene compound and a chelate compound at the time of performing purification can be maintained in a state of a liquid.

Any conventional and known chelate compound can be used as a chelate compound. The chelate compound is preferably a chelate compound comprising a phosphorous atom and an oxygen atom, and more preferably a compound having a plurality of (e.g., two) phosphonic acid structural moieties ($-P(=O)(OH)_2$). For example, a bisphosphonate can be used. Particularly preferable specific examples thereof include etidronic acid.

(Ion exchange)

A polythiophene compound obtained through a polymerization reaction may be optionally subjected to ion exchange to adjust the amount of doping. Ion exchange can be performed with an acidic aqueous solution, ion exchange resin, or the like.

Specifically, when the amount of a hydrogen ion donating group of phosphoric acid or phosphonic acid, monoalkyl phosphate or monoalkyl phosphonate, or monohydrogen phosphate or monohydrogen phosphonate of a polythiophene compound obtained by polymerization is less than a desired amount as the entire polymer, ion exchange of a metal ion or ammonium ion bound to phosphoric acid or phosphonic acid to a hydrogen ion can be performed to increase the effect of doping.

Further, in contrast, when the amount of a hydrogen ion donating group of phosphoric acid or phosphonic acid, monoalkyl phosphate or monoalkyl phosphonate, or monohydrogen phosphate or monohydrogen phosphonate of a polythiophene compound obtained by polymerization is greater than the desired amount as the entire polymer, ion exchange of a hydrogen ion of phosphoric acid or phosphonic acid, monoalkyl phosphate or monoalkyl phosphonate, or monohydrogen phosphate or monohydrogen phosphonate to other ion (e.g., alkali metal ion, ammonium ion, or the like) can be performed to decrease the effect of doping.

Ion exchange can be performed after polymerizing a polythiophene compound. Ion exchange can be performed simultaneously with the above-described purification operation, can be performed before the purification operation, or can be performed after the purification operation. For example, when purification is performed by filtration, ion exchange

can be performed simultaneously with purification through filtration if an ion exchange resin has been loaded into a column used for performing the filtration.

As the ion exchange method, a conventional and known ion exchange method can be used.

If, for example, an acidic aqueous solution is used, then ion exchange can be performed by contacting a polythiophene compound product obtained by polymerization with an acidic aqueous solution. Specifically, ion exchange can be performed, for example, by a method such as stirring a polythiophene compound product in an acidic aqueous solution and reacting a moiety of a salt of a phosphoric acid or phosphonic acid salt compound that is present in the polythiophene compound product with a hydrogen ion in an aqueous solution. When increasing hydrogen ions to increase the effect of doping, it is preferable to use an excessive amount of an acid with respect to an acidic substituent of a polythiophene compound product. In order to decrease the effect of doping, the amount of an acid used may be decreased. In other words, the effect of doping can be set to any level based on the amount of an acid used. Further, the period of time during which a polythiophene compound product and an acid are reacted can also be set to any period of time.

If, for example, an ion exchange resin is used, ion exchange can be performed by a method such as contacting a polythiophene compound product with the ion exchange resin in water. When increasing hydrogen ions in order to increase the effect of doping, it is preferable to use a strongly acidic cation exchange resin. When decreasing hydrogen ions in order to decrease the effect of doping, it is preferable to use a strongly basic cation exchange resin. Any method can be used as a method of contacting a polythiophene compound product with an ion exchange resin. For example, a column may be filled with an ion exchange resin to have a solution comprising a polythiophene compound product flow therein, or an ion exchange resin may be simply placed in a container and a solution comprising a polythiophene compound product may be placed in the container. Further, when contacting a polythiophene compound product with an ion exchange resin, the container thereof may be shaken, or the solution may be stirred to improve the efficiency thereof. The period of time during which a polythiophene compound product and ion exchange resin are contacted can be set to any period of time. If, for example, a small amount (e.g., one droplet) of polythiophene compound product solution is allowed to flow into a column, the period of time is set as a period from when the small amount of solution has contacted the top portion of an ion exchange resin to when the solution leaves from the bottom portion of the ion exchange resin. If, for example, a large amount of polythiophene compound production solution is allowed to flow into a column, then the period of time is set as the average of a period from when the first portion of the solution contacts the top portion of an ion exchange resin to when the first portion leaves the bottom portion of the ion exchange resin and a period from when the last portion of the solution contacts the top portion of the ion exchange resin to when the last portion leaves the bottom portion of the ion exchange resin. Further, when an ion exchange resin and a polythiophene compound product solution are placed in a container, the period of time is set as a period during which the solution and the ion exchange resin are mixed in the container.

The period of time for performing a single operation of ion exchange on a polythiophene compound product (e.g., period of time of contact between the polythiophene compound product and the acidic aqueous solution or period of time of contact between the ion exchange resin and the polythiophene compound product described above) is set to any period of time in accordance with the desired degree of ion exchange. For example, the period of time is preferably 5 seconds or more, more preferably 10 seconds or more, even more preferably 1 minute or more, and still preferably 10 minutes or more. If the contact period of time is too short, then ion exchange tends to be insufficient. Further, the period is preferably 1 day or less, more preferably 12 hours or less, and still preferably 2 hours or less. If the contact period of time is too long, then the entire manufacturing process would take a long period of time, so that the efficiency of manufacture would decrease.

The number of times ion exchange operations are performed is not particularly limited. While ion exchange may be completed by performing an ion exchange operation once on a polythiophene compound product, the ion exchange operation may be repeatedly performed twice or more. If repeated two or more times, then a polythiophene compound having a high doping effect can be readily obtained. Specifically, the operation is preferably repeated three times or more, more preferably repeated four times or more, and still preferably repeated five times or more. Further, the number of times an ion exchange operation is performed is preferably 20 times or less, more preferably 15 times or less, and still preferably 10 times or less. If the number is too high, then the entire manufacturing process would take a long period of time, so that the efficiency of manufacture would decrease.

Further, when performing an ion exchange operation two or more times, the same ion exchange operation may be repeated twice or more times, or two or more types of ion exchange operations may be performed.

In one preferred embodiment, an ion exchange operation can be combined with a purification operation as a series of steps. For example, a polymer having high doping efficiency and high purity can be obtained by adding an acidic aqueous solution to a polythiophene compound product, performing ion exchange thereon, then performing a purification step (e.g., centrifugation) on the polythiophene compound product to remove water, and the like, and retrieving a polythiophene compound wherein the purity is increased. Further, a series of steps wherein an ion exchange operation is combined with a purification operation can be one cycle, and the cycle can be repeated a plurality of times. For example, a polymer having very high doping efficiency and high purity can be efficiently obtained by repeating a series

of steps of adding an acidic aqueous solution to a polythiophene compound product, performing ion exchange thereon, then performing a purification step (e.g., centrifugation) on the polythiophene compound product, retrieving a polythiophene compound wherein the purity is further increases, adding again an acidic aqueous solution to the polythiophene compound after the first purification, performing the second ion exchange, then performing a purification step again, and retrieving a polythiophene compound after the second purification having further improved purity. In other words, a polymer having high purity and high electrical conductivity can be efficiently obtained. The number of times a cycle consisting of a series of steps comprising an ion exchange operation and a purification operation is repeated is not particularly limited. Specifically, the cycle is preferably repeated three times or more, more preferably repeated four times or more, and still preferably repeated five times or more. Further, the cycle is repeated preferably 20 times or less, more preferably 15 times or less, and still preferably 10 times or less. If the number is too high, then the entire manufacturing process would take a long period of time, so that the efficiency of manufacture would decrease.

(Application)

The polythiophene compound of the present invention can be used in various conventional and known applications as the application of an electrically conductive polythiophene compound. Specifically, the polythiophene compound of the present invention can be used, for example, as an antistatic agent or a member of an electrical conductive polymer capacitor. In addition, the polythiophene compound of the present invention can also be used as a material of a hole transport layer in a solar cell.

(Antistatic agent)

As a method of using the polythiophene compound of the present invention for an antistatic agent, various known methods using a conventional electrically conductive polythiophene compound for an antistatic agent can be used. If, for example, the polythiophene compound of the present invention dissolved or dispersed in water or another suitable solvent is coated onto a substrate, an antistatic action is imparted to the surface of the substrate. Examples of the substrate include any solid substance for which an antistatic action is desirable. Specific examples thereof include polymer films, polymer fibers, polymer resin molded articles, and the like.

As a coating method for the polythiophene compound of the present invention, any method used as a method for coating a substrate with a conventional polythiophene compound can be used. Specific examples thereof include spin coating, dip coating, and the like.

(Electrically conductive polymer capacitor)

An electrically conductive polymer capacitor is a type of an electrolytic capacitor using an electrically conductive polymer for an electrolyte or a cathode or cathode electrically conductive layer of the electrolytic capacitor. The polythiophene compound of the present invention can be used for such an electrically conductive polymer.

(Solar cell)

In one embodiment, the polythiophene compound of the present invention can be used as a material for a solar cell. The polythiophene compound of the present invention can be used, for example, for a hole transport layer in a solar cell.

An electrically conductive material for a hole transport layer in a solar cell needs to have not only high electrical conductivity, but also a characteristic for a hole transport layer.

High performance (e.g., high photoelectric conversion efficiency) can be achieved when the polythiophene compound of the present invention is used for a hole transport layer in a solar cell. While the cause is not certain, it is considered that the polythiophene compound of the present invention has some type of an excellent property which is useful for a hole transport layer, such as the energy level matching ITO.

As a method of manufacturing a solar cell, a conventional and known method of manufacturing a solar cell can be used. For example, a method of laminating each layer constituting a solar cell can be used. More specifically, a method comprising a step of forming a hole transport layer comprising a material comprising the polythiophene compound of the present invention and a step of forming other layers constituting a solar cell, or the like can be used. As a material forming a hole transport layer, an aqueous solution of the polythiophene compound of the present invention may be used. Further, an amine such as trimethylamine, triethylamine, tributylamine, diethylamine, and dibutylamine or a base such as ammonia may be optionally added to an aqueous solution of a polythiophene compound and used.

[Examples]

The present invention is described hereinafter with reference to the Examples, but the present invention is not limited in any manner by the Examples.

[Method of measuring electrical conductivity]

The electrical conductivity of the polythiophene compound of the present invention was determined by measuring the electrical conductivity by the following method.

(Production of a test piece)

20 mg of polythiophene compound to be measured was added to water. Thereafter, 1N trimethylamine water was added until the polythiophene compound is dissolved, and an aqueous solution that was 1 ml in total was prepared. A thin film was produced within a circle on a substrate described below by a drop casting method with 20 ul of the aqueous solution, and heated and dried with a hot plate.

Substrate: An alkali-free glass substrate on which a circle with a diameter of 1 cm produced thereon with a polyimide tape was used as the substrate.

(Measurement of electrical conductivity)

The electrical conductivity was calculated from the following formula, with a surface resistance value measured through the 4-point probes method using a low resistivity meter (Nittoseiko Analytech Co., Ltd., LORESTA-GX MCP-T700) and the film thickness measured using a film thickness meter (Mitsutoyo, High-Accuracy Digimatic Micrometer MDH-25MB). Electrical conductivity (S/cm) = 1/(surface resistance value (Ω/□) × film thickness (cm))

[Measurement of absorbance]

A sample was prepared by the following procedure.

Water and trimethylamine were added to a polythiophene compound to be measured and it was dissolved, and the pH was adjusted within the range of 9.2 to 9.4, and a 0.2 wt% polymer solution was prepared. Ultrasound waves were then irradiated thereon for about 1 hour. A UV-ozone treated alkali-free glass substrate (1.3 cm × 2.6 cm) was prepared, and 35 μl of the obtained liquid was drop-casted onto the glass substrate. The substrate was then left standing for 2 hours at ambient temperature in the atmosphere and a dry thin film was obtained.

The absorbance of the obtained thin film sample was measured in the wavelength range of 350 nm to 2500 nm by using a Ultraviolet-visible near infrared absorption spectrometer (JASCO Corporation, V-770). Air was used as a blank. The detector and diffraction grating were switched at 850 nm. A photo-multiplier tube was used in the range of 350 nm to 850 nm, and a cooled PBS photoconductive element was used in the range of 850 nm to 2500 nm. Variation in the absorbance at 1600 nm is an effect of optical feedback due to reflection from the glass substrate.

The absorbance ratio at wavelength X nm was calculated from the following formula.

Absorbance of the composition at wavelength X nm: $A_x$
Absorbance of the composition at a wavelength of 407 nm: $A_{407}$
Absorbance ratio at wavelength X nm = $A_x/A_{407}$

<Synthesis Example 1> Synthesis of thiophene monomer

A mixed solution prepared by adding 0.34 g of paratoluenesulfonic acid monohydrate (1.79 mmol), 75 mL of toluene, 6.76 g of 3-bromo-1,2-propanediol (43.6 mmol), and 2.51 g of 3,4-dimethoxythiophene (17.4 mmol) to a flask was stirred for 24 hours at 100°C, then cooled to room temperature (20 to 25°C). The solids were filtered out with celite, and the filter residue was washed with methylene chloride. The obtained filtrate and the washed solution of the filter residue were mixed. The solvent was distilled off. Thereafter, it was extracted with methylene chloride. The organic phase obtained at the time was dried with sodium sulfate, then the solvent was distilled off. The obtained black liquid was purified by column chromatography and 2.23 g of a white solid compound represented by the following formula (4) was obtained:

[Chemical Formula 4]

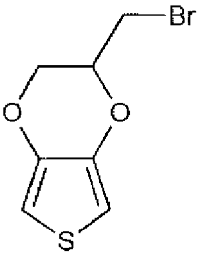

(4) .

0.50 g of the obtained compound represented by formula (4) (2.13 mmol) and 5.0 g of tris(trimethylsilyl)phosphite (16.75 mmol) were added. It was stirred for 24 hours at 150°C, then cooled to room temperature (20 to 25°C). Low boiling-point components such as residual tris(trimethylsilyl)phosphite were then distilled off. Furthermore, 5 mL of 1.5 M ammonium water and 5 mL of methanol were added to the obtained reaction product, and it was stirred for 1 hour. The solvent was distilled off. Thereafter, it was dried under reduced pressure of 133 Pa and 0.51 g of white solid thiophene monomer represented by the following formula (5) was obtained:

[Chemical Formula 5]

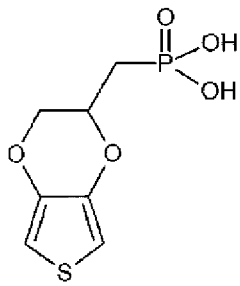

(5) .

<Example 1>

Polythiophene compound 1 was synthesized by the following procedure.

(Synthesis)

0.3 g of the thiophene monomer obtained in Synthesis Example 1 (1.27 mmol), 1.28 g of ferric nitrate nonahydrate (3.17 mmol) as an oxidizing agent, and 5 ml of water were added to a flask and a mixed solution was prepared, which was stirred for 24 h. 1 N hydrochloric acid was added to the obtained mixed solution. It was stirred at room temperature, and a solid was deposited. The solid was filtered out with a Kiriyama Rohto funnel, washed with several ml of acetone, and dried under reduced pressure and a bluish black solid was obtained.

(Purification)

5 ml of water and 7.6 ml of aqueous 4.2 M etidronic acid solution were added to the obtained bluish black solid, and it was stirred for 2 hours at room temperature (20°C to 25°C). The solid was then filtered out with a Kiriyama Rohto funnel, washed with several ml of acetone, and dried under reduced pressure, and 0.18 g of black solid polythiophene compound 1 was obtained. A test piece was produced by the method described above in "Production of a test piece" by using the obtained polythiophene compound 1. The electrical conductivity of the test piece was measured by the method described above in "Measurement of electrical conductivity". The absorbance of polythiophene compound 1 was measured by the method described above in "Measurement of absorbance" and the absorbance ratio was calculated. The results thereof are shown in Figure 1 and Table 1.

<Example 2>

Polythiophene compound 2 was synthesized by the following procedure.

(Synthesis)

0.3 g of the thiophene monomer obtained in Synthesis Example 1 (1.27 mmol), 2.11 g of ferric sulfate nonahydrate (3.75 mmol) as an oxidizing agent, and 4 ml of water were added to a flask and a mixed solution was prepared, which was stirred for 7 h. A solution prepared by adding 0.37 g of ammonium persulfate (1.65 mmol) to 3 ml of water was then added dropwise over 17 h. 1 N hydrochloric acid was added to the obtained mixed solution and it was stirred at room temperature, and a solid was deposited. The solid was filtered out with a Kiriyama Rohto funnel, washed with several ml of acetone, and dried under reduced pressure, and a bluish black solid was obtained.

(Purification)

The obtained bluish black solid was subjected to the same purification operation as the purification operation in Example 1 and 0.25 g of bluish black solid polythiophene compound 2 was obtained. A test piece was produced by the method described above in "Production of a test piece" by using the obtained polythiophene compound 2. The electrical conductivity of the test piece was measured by the method described above in "Measurement of electrical conductivity". The absorbance of polythiophene compound 2 was measured by the method described above in "Measurement of absorbance", and the absorbance ratio was calculated. The results thereof are shown in Figure 1 and Table 1.

<Example 3>

Polythiophene compound 3 was synthesized by the following procedure.

(Synthesis)

The same operation as the synthesis in Example 1 was performed, except for using 0.86 g of ferric chloride hexahydrate (3.18 mmol) as the oxidizing agent, and a bluish black solid was obtained.

(Purification)

The obtained bluish black solid was subjected to the same purification operation as the purification operation in Example 1 and 0.13 g of bluish black solid polythiophene compound 3 was obtained. A test piece was produced by the method described above in "Production of a test piece" by using polythiophene compound 3. The electrical conductivity of the test piece was measured by the method described above in "Measurement of electrical conductivity". The absorbance of polythiophene compound 3 was measured by the method described above in "Measurement of absorbance", and the absorbance ratio was calculated. The results thereof are shown in Figure 1 and Table 1.

<Example 4>

Polythiophene compound 4 was synthesized by the following procedure.

(Synthesis)

The same operation as the synthesis in Example 1 was performed, except for using 2.15 g of ferric paratoluenesulfonate hexahydrate (3.18 mmol) as the oxidizing agent, and a bluish black solid was obtained.

(Purification)

The obtained bluish black solid was subjected to the same purification operation as the purification operation in Example 1, and 0.18 g of bluish black solid polythiophene compound 4 was obtained. A test piece was produced by the method described above in "Production of a test piece" by using polythiophene compound 4. The electrical conductivity of the test piece was measured by the method described above in "Measurement of electrical conductivity". The absorbance of polythiophene compound 4 was measured by the method described above in "Measurement of absorbance", and the absorbance ratio was calculated. The results thereof are shown in Figure 1 and Table 1.

<Example 5>

Polythiophene compound 5 was synthesized by the following procedure.

(Synthesis)

The same operation as the synthesis in Example 1 was performed, except for using 2.86 g of ferric sulfate nonahydrate (5.08 mmol) as the oxidizing agent, and a bluish black solid was obtained.

(Purification)

The obtained bluish black solid was subjected to the same purification operation as the purification operation in Example 1, and 0.24 g of bluish black solid polythiophene compound 5 was obtained. A test piece was produced by the method described above in "Production of a test piece" by using polythiophene compound 5. The electrical conductivity of the test piece was measured by the method described above in "Measurement of electrical conductivity". The absorbance of polythiophene compound 5 was measured by the method described above in "Measurement of absorbance", and the absorbance ratio was obtained. The results thereof are shown in Figure 1 and Table 1.

<Comparative Example 1>

Example 4 in Japanese Laid-Open Publication No. 2018-48322 describes that the electrical conductivity of the polymerization product of the thiophene monomer in Synthesis Example 1 was 0.27 S/m. If this value is converted into a unit of cm, then the value is $2.7 \times 10^{-3}$ S/cm. However, this value cannot be directly compared with the results of the Examples described above because the measurement method is different from that of the present application.

For this reason, polythiophene compound 6 was synthesized by the same method as Example 4 in Japanese Laid-Open Publication No. 2018-48322. A test piece was produced by the method described above in "Production of a test piece" by using polythiophene compound 6. The electrical conductivity of the test piece was measured by the method described above in "Measurement of electrical conductivity". The absorbance of polythiophene compound 6 was measured by the method described above in "Measurement of absorbance", and the absorbance ratio was calculated. The results thereof are shown in Figure 1 and Table 1.

<Comparative Example 2>

Polythiophene compound 7 was synthesized by the following procedure.

The same operation as the synthesis in Example 5 was performed, but the purification was not performed, and 0.3 g of polythiophene compound 7 was obtained.

A test piece was produced by the method described above in "Production of a test piece" by using the obtained polythiophene compound 7. The electrical conductivity of the test piece was measured by the method described above in "Measurement of electrical conductivity". The absorbance of polythiophene compound 7 was measured by the method described above in "Measurement of absorbance", and the absorbance ratio was calculated. The results thereof are shown in Figure 1 and Table 1.

<Comparative Example 3>

Polythiophene compound 8 was synthesized by the following procedure.

0.3 g of thiophene monomer obtained in Synthesis Example 1 (1.27 mmol), 2.86 g of ferric sulfate nonahydrate (5.08 mmol) as an oxidizing agent, and 5 ml of water were added to a flask, and a mixed solution was prepared, which was stirred for 24 h. Several ml of diethyl ether was added to the obtained mixed solution, and the deposited solid was filtered out, and 0.3 g of a bluish black solid polythiophene compound 8 was obtained.

A test piece was produced by the method described above in "Production of a test piece" by using polythiophene compound 8. The electrical conductivity of the test piece was measured by the method described above in "Measurement of electrical conductivity". The absorbance of polythiophene compound 8 was measured by the method described above in "Measurement of absorbance", and the absorbance ratio was calculated. The results thereof are shown in Figure 1 and Table 1.

(Synthesis of polythiophene compound 9)

<Synthesis Example 2> Synthesis of a thiophene monomer

A mixed solution of 4.6 g of the compound represented by formula (4) obtained in Synthesis Example 1 (19.5 mmol), 3.1 g of potassium acetate (31.6 mol), 3.3 g of triethylamine (32.6 mol), and 45 ml of dimethyl sulfoxide was stirred for 14 hours at 100°C, then cooled to room temperature (20 to 25°C). Toluene and water were added, and

thereafter, it was left standing for separation. The organic layer obtained by separation was washed with water, then the solvent was removed, and 3.9 g of brown liquid compound represented by the following formula (6) was obtained:

[Chemical Formula 6]

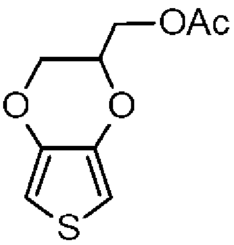

(6).

A mixed solution of 3.9 g of the obtained compound represented by formula (6) (18.2 mmol), 2.7 g of 30% sodium hydroxide aqueous solution (20.2 mmol), and water was stirred for 10 hours at 100°C, then cooled to room temperature (20 to 25°C). 2.2 g of 35 wt% hydrochloric acid (hydrogen chloride aqueous solution), dichloromethane, and water were added, and it was stirred and then left standing for separation. Dichloromethane, ethyl acetate, and 2.0 g of 35 wt% hydrochloric acid were added to the aqueous layer obtained by separation, and it was stirred and then left standing for separation. The solvent was removed from the organic layer obtained by the separation, and 2.9 g of brown liquid compound represented by the following formula (7) was obtained:

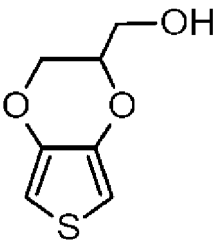

(7).

65 g of 30% sodium hydroxide aqueous solution (487.5 mmol) was added dropwise to a mixed solution of 1.0 g of the obtained compound represented by formula (7) (5.81 mmol), 12.7 g of 1,4-dibromobutane (58.8 mmol), 1.0 g of tetrabutylammonium bromide (3.10 mmol), and 3.6 ml of THF for 15 minutes in an ice bath, and it was stirred for 2.5 hours at room temperature. Water, ethyl acetate, and hexane were then added, and it was stirred and then left standing for separation. The organic layer obtained by separation was washed with water and dehydrated with anhydrous sodium sulfate. The solvent was then removed, and it was purified by silica gel column chromatography, and 1.7 g of white solid compound represented by the following formula (9A) was obtained:

[Chemical Formula 9A]

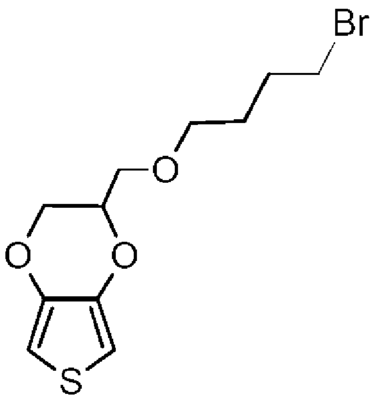

(9A).

A mixed liquid of 1.5 g of the obtained compound represented by formula (9A) (4.88 mmol) and 2.0 g tris(trimethylsilyl)phosphite (6.7 mmol) was stirred for 24 hours at 150°C, then cooled to room temperature (20 to 25°C). Low boiling-point components such as the residual tris(trimethylsilyl)phosphite were distilled off. Furthermore, 5 mL of 1.5 M ammonia water and methanol were added to the obtained reaction product. It was stirred for 1 hour, and then the solvent was distilled off. It was then dried under reduced pressure, and 1.0 g of white solid thiophene monomer represented by the following formula (9B) was obtained:

[Chemical Formula 9B]

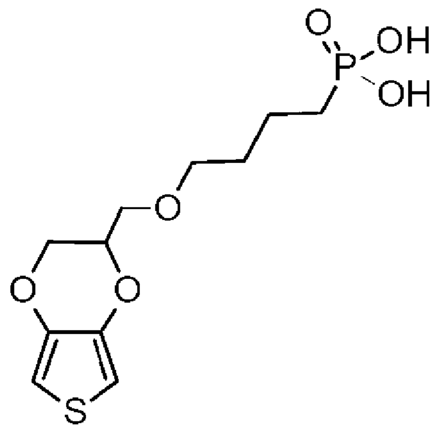

(9B).

<Example 6>

Polythiophene compound 9 was synthesized by the following procedure.

(Synthesis)

A mixed solution was prepared by adding 0.3 g of the thiophene monomer (formula (9B)) obtained in Synthesis Example 2 (0.97 mmol), 2.1 g of ferric chloride hexahydrate (7.8 mmol) as an oxidizing agent, and 1.3 ml of each of water and dimethylformamide, and was stirred for 3 hours. Thereafter, a solution prepared by mixing 0.16 g of ammonium persulfate (0.70 mmol), 1.3 ml of water, and 1.3 ml of dimethylformamide was added dropwise over 4.5 hours. 1 N hydrochloric acid was added to the obtained mixed solution, and it was stirred at room temperature, and a solid was deposited. The solid was filtered out with a Kiriyama Rohto funnel, washed with several ml of acetone, and dried under reduced pressure, and a bluish black solid was obtained.

(Purification)

The obtained bluish black solid was subjected to the same purification operation as the purification in Example 1, and 0.1 g of bluish black solid polythiophene compound 9 was obtained. A test piece was produced by the method described above in "Production of a test piece" by using polythiophene compound 9. The electrical conductivity of the test piece was measured by the method described above in "Measurement of electrical conductivity". The absorbance of polythiophene compound 9 was measured by the method described above in "Measurement of absorbance", and the absorbance ratio was calculated. The results thereof are shown in Figure 1 and Table 1.

[Chemical Formula 9]

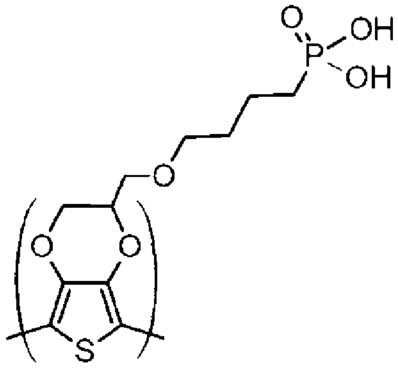

(9)

(Synthesis of polythiophene compound 10)

<Synthesis Example 3> Synthesis of a thiophene monomer

15.5 g of 30% sodium hydroxide aqueous solution (116 mmol) was added dropwise to a mixed solution of 1.0 g of the compound represented by formula (7) obtained in Synthesis Example 2 (5.81 mmol), 15.0 g of 1,3-dibromopropane (74.2 mmol), 0.26 g of tetrabutylammonium bromide (0.81 mmol), and 3.6 ml of THF for 15 minutes in an ice bath. It was stirred for 9.5 hours. Subsequently, water, ethyl acetate, and hexane were added. It was stirred and then left standing for separation. The organic layer obtained by separation was dehydrated by adding anhydrous sodium sulfate. The solvent was removed, and it was purified by silica gel column chromatography, and 0.6 g of transparent liquid compound represented by the following formula (10A) was obtained:

[Chemical Formula 10A]

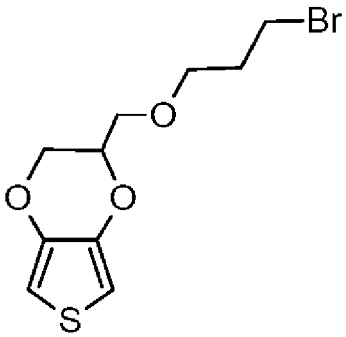

(10A).

The obtained compound represented by formula (10A) was used, and the same method as the method by which the compound of formula (9B) was obtained from the compound of formula (9A) in Synthesis Example 2 was performed, and a compound represented by formula (10B) was obtained.

[Chemical Formula 10B]

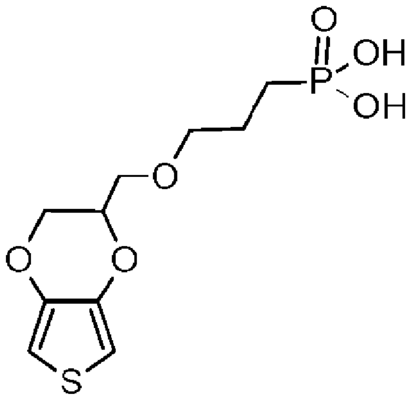

(10B)

<Example 7>

Polythiophene compound 10 was synthesized by the following procedure.

(Synthesis)

The same operation as the synthesis in Example 1 was performed, except for using 0.3 g of the thiophene monomer (formula 10B) obtained in Synthesis Example 3 (1.02 mmol) and 2.3 g of ferric sulfate nonahydrate (4.09 mmol) as the oxidizing agent, and a bluish black solid was obtained.

(Purification)

The obtained bluish black solid was used, and an operation which is the same as the purification in Example 1 was performed, and 0.3 g of bluish black solid polythiophene compound 10 was obtained. polythiophene compound 10 was used and a test piece was produced by the method described above in "Production of a test piece". The electrical conductivity of the test piece was measured by the method described above in "Measurement of electrical conductivity". The absorbance of polythiophene compound 10 was measured by the method described above in "Measurement of absorbance", and the absorbance ratio was calculated. The results thereof are shown in Figure 1 and Table 1.

[Chemical Formula 10]

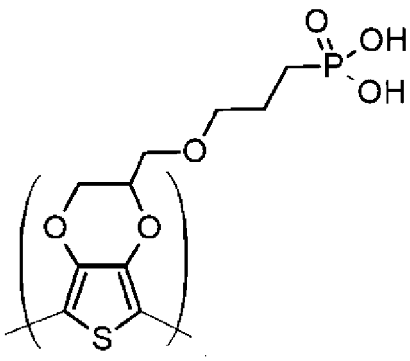

(10)

(Synthesis of polythiophene compound 11)

<Synthesis Example 4> Synthesis of a thiophene monomer

A mixed solution of 0.7 g of phosphorus oxychloride (4.76 mmol) and 4 ml of cyclopentyl methyl ether was added dropwise to a mixed solution of 0.6 g of the compound represented by formula (7) obtained in Synthesis Example 2 (3.48 mmol), 0.5 g of triethylamine (4.95 mmol), and 12 ml of cyclopentyl methyl ether over 10 minutes in an ice bath.

It was then stirred for 2.5 hours. Subsequently, triethylamine hydrochloride in the reaction solution was removed by filtration, and 20 ml of aqueous 1M ammonia solution was added to the filtrate, and it was stirred for 2.5 hours. Water and cyclopentyl methyl ether were then added, and it was left standing for separation. 0.26 g of calcium hydroxide (3.51 mmol) and water were added to the aqueous layer obtained by separation, and white precipitation was obtained, which was collected by filtration and washed with water. Calcium ions were then removed by a cation exchange resin. It was dehydrated under reduced pressure, and 0.2 g of milky-white solid represented by the following formula (11C) was obtained:

[Chemical Formula 11C]

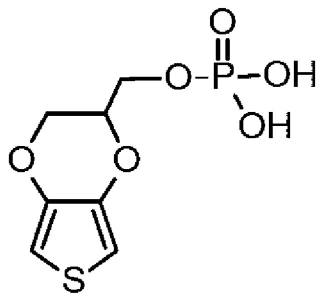

(1 1 C) .

<Example 8>

Polythiophene compound 11 was synthesized by the following procedure.

(Synthesis)

The same operation as the synthesis in Example 1 was performed, except for using 0.3 g of the thiophene monomer (formula 11C) obtained in Synthesis Example 4 (1.19 mmol) and 2.7 g of ferric sulfate nonahydrate (4.80 mmol) as the oxidizing agent. A bluish black solid was obtained.

(Purification)

The obtained bluish black solid was used and the same operation as the purification in Example 1 was performed, and 0.2 g of bluish black solid polythiophene compound 11 was obtained. A test piece was produced by the method described above in "Production of a test piece" by using polythiophene compound 11. The electrical conductivity of the test piece was measured by the method described above in "Measurement of electrical conductivity". The absorbance of polythiophene compound 11 was measured by the method described above in "Measurement of absorbance", and the absorbance ratio was calculated. The results thereof are shown in Figure 1 and Table 1.

[Chemical Formula 11]

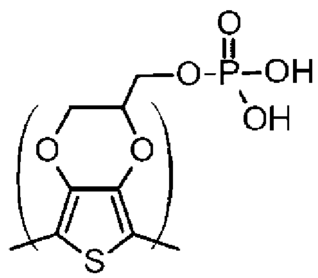

(1 1)

The results described above are summarized in the following table.

[Table 1]

| | Polythiophene compound | Absorbance ratio at wavelength of 2000 nm | Electrical conductivity S/cm | Oxidizing agent | Purification condition |
|---|---|---|---|---|---|
| Example 1 | Polythiophene compound 1 | **2.6** | **5.0**$\times 10^{-1}$ | $Fe(NO_3)_3$ | HEDP chelate purification |
| Example 2 | Polythiophene compound 2 | **2.4** | **1.8** | $Fe_2(SO_4)_3$+APS | HEDP chelate purification |
| Example 3 | Polythiophene compound 3 | **4.0** | **7.3** | $FeCl_3$ | HEDP chelate purification |
| Example 4 | Polythiophene compound 4 | **4.1** | **3.3$\times$10** | $Fe(OTs)_3$ | HEDP chelate purification |
| Example 5 | Polythiophene compound 5 | **4.5** | **1.3**$\times 10^{2}$ | $Fe_2(SO_4)_3$ | HEDP chelate purification |
| Comparative Example 1 | Polythiophene compound 6 | **0.8** | **2.5**$\times 10^{-4}$ | APS | Ion exchange resin + ether washing |
| Comparative Example 2 | Polythiophene compound 7 | **0.8** | **3.3**$\times 10^{-4}$ | $Fe_2(SO_4)_3$ | No purification |
| Comparative Example 3 | Polythiophene compound 8 | **0.6** | **3.6**$\times 10^{-4}$ | $Fe_2(SO_4)_3$ | Ether washing |
| Example 6 | Polythiophene compound 9 | **6.0** | **3.4$\times$10** | $FeCl_3$+APS | HEDP chelate purification |
| Example 7 | Polythiophene compound 10 | **4.6** | **5.2$\times$10** | $Fe_2(SO_4)_3$ | HEDP chelate purification |
| Example 8 | Polythiophene compound 11 | **4.5** | **2.7$\times$10** | $Fe_2(SO_4)_3$ | HEDP chelate purification |

*APS; ammonium persulfate
$Fe_2(SO_4)_3$; iron(III) sulfate nonahydrate
$FeCl_3$; iron(III) chloride hexahydrate
$Fe(OTs)_3$; iron(III) para-toluenesulfonate hexahydrate
$Fe(NO_3)_3$; iron(III) nitrate nonahydrate

The absorbance ratio at the wavelength of 2000 nm was low in each of Comparative Examples 1 to 3. Since it is considered that the absorbance ratio at a wavelength of 2000 nm reflects the level of a bipolaron state, it is understood that the level of a bipolaron state is low in each of Comparative Examples 1 to 3. On the other hand, the absorbance ratio at a wavelength of 2000 nm was high in each of Examples 1 to 8. For this reason, it is understood that the level of a bipolaron state is high in each of Examples 1 to 8.

When Examples 1 to 8 and Comparative Examples 1 to 3 are compared, the electrical conductivity was 2.5 to $3.6 \times 10^{-4}$ S/cm in Comparative Examples 1 to 3, whereas the electrical conductivity was $5.0 \times 10^{-1}$ to $1.3 \times 10^{2}$ S/cm in Examples 1 to 8. In particular, the electrical conductivity was 7.3 to $1.3 \times 10^{2}$ S/cm in Examples 3 to 8.

In other words, the electrical conductivity in the Examples was about 1000-fold or greater relative to the electrical conductivity in the Comparative Examples. In particular, the electrical conductivity in Examples 3 to 8 where the absorbance ratio at a wavelength of 2000 nm was 3 or greater was about 20000-fold or greater relative to the electrical conductivity in the Comparative Examples.

Thus, a polythiophene compound having an absorbance ratio at a wavelength of 2000 nm of 1 or greater can achieve significantly higher electrical conductivity than a polythiophene compound having an absorbance ratio at a wavelength of 2000 nm of less than 1. Further, in particular, a polythiophene compound having an absorbance ratio at a wavelength of 2000 nm of 3 or greater or 4 or greater can achieve extremely high electrical conductivity.

It can be understood in view of the above that dramatically high electrical conductivity is achieved by the polythiophene compound of the present invention. The present invention provides a compound and an electrically conductive material composition having extremely high electrical conductivity.

<Example 9>

(Preparation of hole transport layer film forming material)

(Preparation of polythiophene compound 5/DBA solution (hole transport layer film forming material 1))

Polythiophene compound 5 synthesized in Example 5, n-dibutylamine, and distilled water were mixed. The obtained mixture was irradiated with ultrasound waves for 3 hours. In doing so, it was adjusted so that polythiophene compound 5 would be 1.8 wt% and n-dibutylamine would be 1.9 wt%. The remaining 96.3 wt% was water. The obtained solution was used in the preparation of a solar cell as hole transport layer film forming material 1.

<Comparative Example 4>

(Preparation of a PEDOT:PSS dispersion (hole transport layer film forming material 2))

A commercially available dispersant of polyethylenedioxyorthothiophene-polystyrene sulfonic acid associate (referred to as "PEDOT:PSS" in the present specification) (total amount of polyethylenedioxyorthothiophene and polystyrene sulfonate is 2.8 wt% in the dispersion) (Sigma Aldrich, dispersion medium: water) and distilled water were mixed and stirred for 21 hours. In doing so, it was adjusted so that the total amount of polyethylenedioxyorthothiophene and polystyrene sulfonic acid would be 1.1 wt% in the obtained dispersion. The obtained dispersion was used in the preparation of a solar cell as hole transport layer film forming material 3.

(Preparation of a solar cell (device for evaluation))

An ITO electrode was laminated on a glass substrate. A film was formed on an ITO(+) electrode by a spin coating method by using the hole transport layer film forming material 1 obtained in Example 9 or the hole transport layer film forming material 2 obtained in Comparative Example 4, and heated at 150°C to laminate a hole transport layer. Zinc phthalocyanine (ZnPc), fullerene ($C_{70}$), bathocuproine (BCP), and aluminum (Al) were then laminated in this order by a vacuum vapor deposition method. A laminated device was obtained, wherein, the second layer (ITO electrode) was laminated at a thickness of 150 nm on the first layer (glass substrate); the third layer (hole transport layer) was laminated at a thickness of 30 nm on the second layer; the fourth layer (zinc phthalocyanine (ZnPc), p-type, photoelectric conversion layer) was laminated at a thickness of 30 nm on the third layer; the fifth layer (fullerene ($C_{70}$), n-type, photoelectric conversion layer) was laminated at a thickness of 30 nm on the fourth layer; the sixth layer (bathocuproine (BCP), electron transport layer) was laminated at a thickness of 12 nm on the fifth layer; and the seventh layer (aluminum (Al)) was laminated at a thickness of 60 nm on the sixth layer. Figure 2 shows the obtained laminated structure of the device.

The chemical structures of ZnPc and BCP are the following. ZnPc (zinc phthalocyanine)

[Chemical Formula 31]

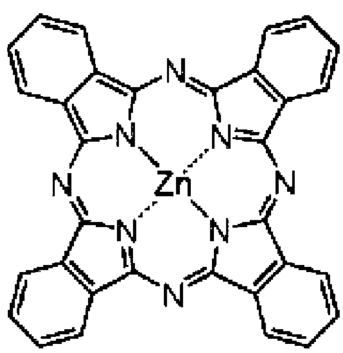

BCP (Bathocuproine)

[Chemical Formula 32]

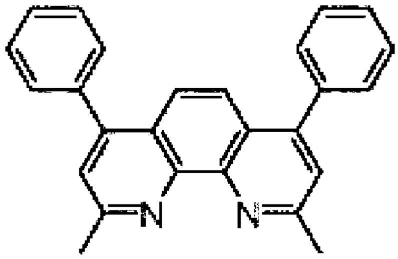

24 devices for evaluation using hole transport layer film forming material 1 for a hole transport layer and 24 devices for evaluation using hole transport layer film forming material 2 for a hole transport layer were prepared.

(Evaluation of solar cells (devices for evaluation))

(Evaluation of current density-voltage (J-V) characteristics)

First, among the prepared devices for evaluation described above, those having clear electrical conduction between electrodes when J-V characteristics in the dark were measured with a source meter (Keithley, model: 2400) and those having a large leakage current at the time of application of a reverse bias were excluded as defective cells. The remaining 21 devices using hole transport layer film forming material 1 and 23 devices using hole transport layer film forming material 2 were irradiated with Simulated solar light (AM1.5 G, 100 mW $cm^{-2}$). The J-V characteristics under irradiation were measured with a source meter. The short-circuit current (Jsc), open circuit voltage (Voc), fill factor (FF), and photoelectric conversion efficiency (PCE) (%) were calculated from the measurement results. The results are shown in the following table.

[Table 2]

| Hole transport layer | Number of devices used | $V_{OC}$ /V mean value (max value) | $J_{SC}$ /mA$cm^{-2}$ mean value (max value) | FF mean value (max value) | PCE /% mean value (max value) |
|---|---|---|---|---|---|
| Hole transport layer film forming material 1 (Example 9) | 21 | 0.495 (0.503) | 10.23 (12.54) | 0.450 (0.488) | 2.27 (2.70) |
| Hole transport layer film forming material 2 (Comparative Example 4) | 23 | 0.500 (0.507) | 6.39 (8.15) | 0.301 (0.358) | 0.98 (1.42) |

As compared to the case where hole transport layer film forming material 2 in Comparative Example 4 was used, in the case where hole transport layer film forming material 1 in Example 9 was used, both mean value and maximum value of photoelectric conversion efficiency (PCE) were significantly higher.

Figure **3** shows a structure of the device shown in Figure **2** wherein a voltage applying device is connected between the ITO layer and the Al layer. A source meter was used as the voltage applying device in Figure **3** in the measurement of the *J-V* characteristics described above.

The graph of Figure **4** shows the relationship of each parameter and *J-V* characteristics. The horizontal axis is the voltage (*V*) and the vertical axis is the current density *J*/mA $cm^{-2}$ in the graph of Figure **4.** The current density at the time of light irradiation is indicated by the solid line, and the current density when light is not irradiated (in the dark) is indicated by the dotted line. The arrow indicating the difference therebetween indicates a photoelectric current.

Open circuit voltage (*Voc*) is the voltage at which the current density is 0. Short-circuit current density (*Jsc*) is the current density at which the voltage is 0.

Fill factor (FF) is calculated using the following formula from the voltage (*V*max) and current density (*J*max) at the maximum output point.

$$FF = (J\max \times V\max)/(Jsc \times Voc)$$

Photoelectric conversion efficiency (PCE) is calculated using the following formula.

$$PCE = (Jmax \times Vmax)/\text{irradiated light energy}$$
$$= (Voc \times Jsc \times FF)/\text{irradiated light energy}$$

The graph of Figure **5** shows typical *J-V* characteristics at the time of light irradiation for devices using a hole transport layer of hole transport layer film forming material 1 or hole transport layer film forming material 2 described above. The horizontal axis is the voltage (*V*) and the vertical axis is the current density *J*/mAcm$^{-2}$ in the graph of Figure **5.** The current density when using polythiophene compound 5/DBA (hole transport layer film forming material 1) is indicated by the solid line. The current density when using PEDOT:PSS (hole transport layer film forming material 2) is indicated by the dotted line.

(Evaluation of change in PCE over time)

The devices described above were shielded away from light and stored within a nitrogen substituted glovebox. The change in *J-V* characteristics at the time of light irradiation over time was tracked therethrough and thereby the behavior of the decrease in the characteristics of the devices during storage was studied.

Among the results showing normalized changes of PCE over time (the initial value is converted to 1), those which are typical are shown in Figure 6. The horizontal axis indicates the elapsed time and the vertical axis indicates the value of normalized PCE value (i.e., a ratio of the value of PCE after a certain period of time has elapsed to the initial value of PCE). The normalized PCE values for polythiophene compound 5/DBA (hole transport layer film forming material 1) are indicated by squares. The normalized PCE values for PEDOT:PSS (hole transport layer film forming material 3) are indicated by triangles.

PCE was decreased with passage of time in each device, but the rate of decrease was more moderate for polythiophene compound 5/DBA (hole transport layer film forming material 1) than for PEDOT:PSS (hole transport layer film forming material 2). Specifically, PCE after 45 days of storage was about 50% of the PCE on the first day for hole transport layer film forming material 1. On the other hand, PCE after 45 days of storage was about 20% of the PCE on the first day for hole transport layer film forming material 2. Thus, hole transport layer film forming material 1 was confirmed to be significantly better than hole transport layer film forming material 2 in terms of the stability of PCE.

In view of the results described above, it is understood that the electrically conductive material of the present invention has not only excellent electrical conductivity, but also a suitable characteristic for a hole transport layer in a solar cell.

[Industrial Applicability]

The present invention provides a polythiophene compound and an electrically conductive material composition having excellent electrical conductivity. The polythiophene compound and electrically conductive material composition of the present invention can be applied in various applications such as antistatic agents, condensers, organic ELs, secondary cells, capacitors, static preventing agents, solar cells, electrode materials for a plastic electrode, EMI materials, organic ferromagnets, electrochromic materials, and various sensors.

As disclosed above, the present invention is exemplified by the use of its preferred embodiments. However, the present invention should not be interpreted to be limited to such embodiments. It is understood that the scope of the present invention should be interpreted based solely on the claims. It is understood that those skilled in the art can implement an equivalent scope, based on the descriptions of the invention and common general knowledge, from the descriptions of the specific preferred embodiments of the invention. It is understood that any patent, any patent application, and any reference cited herein should be incorporated herein by reference in the same manner as the contents are specifically described herein.

## Claims

**1.** A polythiophene compound comprising a structural unit represented by the following general formula (A):

[Chemical Formula 1]

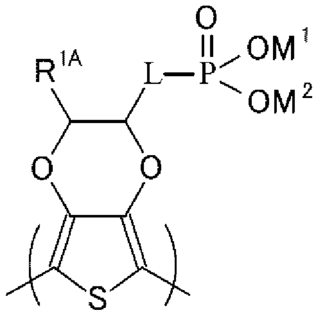

(A)

wherein L is represented by formula (21):

[Chemical Formula 21]

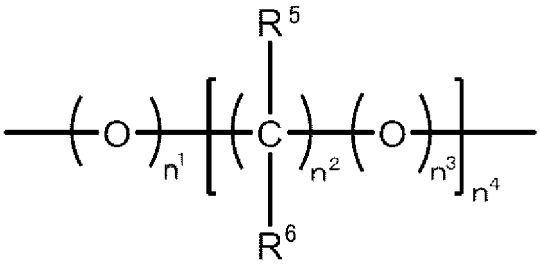

(21)

wherein $R^5$ is independently a hydrogen atom or a straight chain or branched chain alkyl group in which the number of carbon atoms is 1 to 5, $R^6$ is independently a hydrogen atom or a straight chain or branched chain alkyl group in which the number of carbon atoms is 1 to 5, $n^1$ is 0 or 1, $n^2$ is independently an integer from 1 to 6, $n^3$ is independently 0 or 1, $n^4$ is an integer from 0 to 12, and the left end of formula (21) is bound to the carbon atom in the dioxane ring in formula (A),

$M^1$ and $M^2$ are each independently an alkyl group in which the number of carbon atoms is 1 to 15, a hydrogen atom, an alkali metal, an alkaline earth metal, or an ammonium group, with the proviso that if one of $M^1$ and $M^2$ is an alkaline earth metal, then the compound has a structure in which the alkaline earth metal atom is bound to two $O^-$ in one phosphoric acid or phosphonic acid moiety and the other of $M^1$ and $M^2$ is not present, or the compound has a structure in which the alkaline earth metal atom crosslinks $O^-$ of two phosphoric acid or phosphonic acid moieties,

if at least one of $M^1$ and $M^2$ is a hydrogen atom, then the compound may be bound to a basic substance at a moiety of the hydrogen atom to form a salt,

$R^{1A}$ is a hydrogen atom, an alkyl group, an alkoxy group, an acyl group, or a group represented by formula (15):

[Chemical Formula 15]

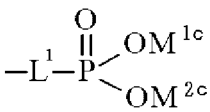

(15)

wherein $L^1$ is represented by formula (22):

[Chemical Formula 22]

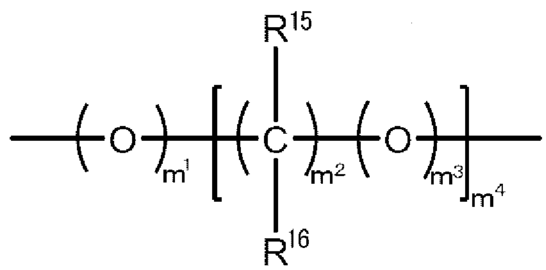

(22)

wherein $R^{15}$ is independently a hydrogen atom or a straight chain or branched chain alkyl group in which the number of carbon atoms is 1 to 5, $R^{16}$ is independently a hydrogen atom or a straight chain or branched chain alkyl group in which the number of carbon atoms is 1 to 5, $m^1$ is 0 or 1, $m^2$ is independently an integer from 1 to 6, $m^3$ is independently 0 or 1, $m^4$ is an integer from 0 to 12, and the left end of formula (22) is bound to the carbon atom in the dioxane ring in formula (A),

$M^{1c}$ and $M^{2c}$ are each independently an alkyl group in which the number of carbon atoms is 1 to 15, a hydrogen atom, an alkali metal, an alkaline earth metal, or an ammonium group, with the proviso that if one of $M^{1c}$ and $M^{2c}$ is an alkaline earth metal, then the compound has a structure in which the alkaline earth metal atom is bound to two $O^-$ in one phosphoric acid or phosphonic acid moiety and the other of $M^{1c}$ and $M^{2c}$ is not present, or the compound has a structure in which the alkaline earth metal atom crosslinks $O^-$ of two phosphoric acid or phosphonic acid moieties,

if at least one of $M^{1c}$ and $M^{2c}$ is a hydrogen atom, then the compound may be bound to a basic substance at a moiety of the hydrogen atom to form a salt,

wherein an absorbance ratio calculated using a calculation formula ($A_{2000}/A_{407}$) from absorbance ($A_{2000}$) of the compound at a wavelength of 2000 nm and absorbance ($A_{407}$) of the compound at a wavelength of 407 nm measured using a spectrophotometer is 1 or greater.

**2.** An electrically conductive material composition comprising a polythiophene compound,

the polythiophene compound comprising a structural unit represented by the following general formula (A):

[Chemical Formula 1]

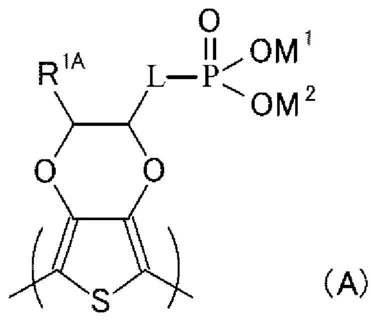

(A)

wherein L is represented by formula (21):

[Chemical Formula 21]

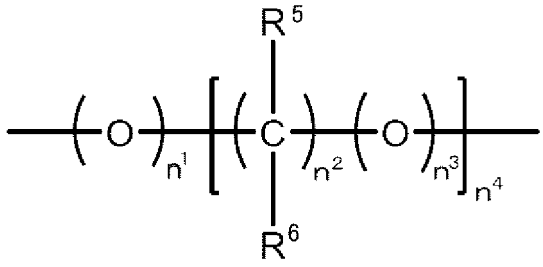

(21)

wherein $R^5$ is independently a hydrogen atom or a straight chain or branched chain alkyl group in which the number of carbon atoms is 1 to 5, $R^6$ is independently a hydrogen atom or a straight chain or branched chain alkyl group in which the number of carbon atoms is 1 to 5, $n^1$ is 0 or 1, $n^2$ is independently an integer from 1 to 6, $n^3$ is independently 0 or 1, $n^4$ is an integer from 0 to 12, and the left end of formula (21) is bound to the carbon atom in the dioxane ring in formula (A),

$M^1$ and $M^2$ are each independently an alkyl group in which the number of carbon atoms is 1 to 15, a hydrogen atom, an alkali metal, an alkaline earth metal, or an ammonium group, with the proviso that if one of $M^1$ and $M^2$ is an alkaline earth metal, then the compound has a structure in which the alkaline earth metal atom is bound to two $O^-$ in one phosphoric acid or phosphonic acid moiety and the other of $M^1$ and $M^2$ is not present, or the compound has a structure in which the alkaline earth metal atom crosslinks $O^-$ of two phosphoric acid or phosphonic acid moieties,

if at least one of $M^1$ and $M^2$ is a hydrogen atom, then the compound may be bound to a basic substance at a moiety of the hydrogen atom to form a salt,

$R^{1A}$ is a hydrogen atom, an alkyl group, an alkoxy group, an acyl group, or a group represented by formula (15):

[Chemical Formula 15]

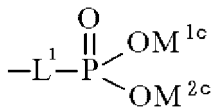

(15)

wherein $L^1$ is represented by formula (22):

[Chemical Formula 22]

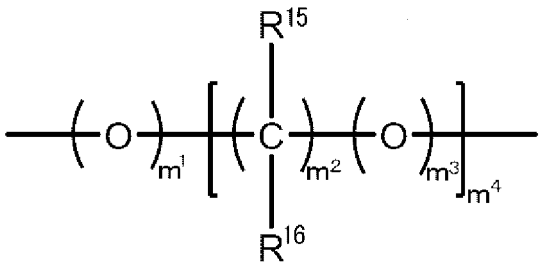

(22)

wherein $R^{15}$ is independently a hydrogen atom or a straight chain or branched chain alkyl group in which the number of carbon atoms is 1 to 5, $R^{16}$ is independently a hydrogen atom or a straight chain or branched chain alkyl group in which the number of carbon atoms is 1 to 5, $m^1$ is 0 or 1, $m^2$ is independently an integer from 1 to 6, $m^3$ is independently 0 or 1, $m^4$ is an integer from 0 to 12, and the left end of formula (22) is bound to the carbon atom in the dioxane ring in formula (A),

$M^{1c}$ and $M^{2c}$ are each independently an alkyl group in which the number of carbon atoms is 1 to 15, a hydrogen atom, an alkali metal, an alkaline earth metal, or an ammonium group, with the proviso that if one of $M^{1c}$ and $M^{2c}$ is an alkaline earth metal, then the compound has a structure in which the alkaline earth metal atom is bound to two $O^-$ in one phosphoric acid or phosphonic acid moiety and the other of $M^{1c}$ and $M^{2c}$ is not present, or the compound has a structure in which the alkaline earth metal atom crosslinks $O^-$ of two phosphoric acid or

phosphonic acid moieties,
if at least one of $M^{1c}$ and $M^{2c}$ is a hydrogen atom, then the compound may be bound to a basic substance at a moiety of the hydrogen atom to form a salt,
wherein an absorbance ratio calculated using a calculation formula ($A_{2000}/A_{407}$) from absorbance ($A_{2000}$) of the composition at a wavelength of 2000 nm and absorbance ($A_{407}$) of the composition at a wavelength of 407 nm measured using a spectrophotometer is 1 or greater.

**3.** The electrically conductive material composition of claim 2, wherein the absorbance ratio is 2 or greater.

**4.** The electrically conductive material composition of claim 2 or 3, wherein at least one of $M^1$ and $M^2$ comprises a structural unit selected from a hydrogen atom, an alkali metal, an alkaline earth metal, and an ammonium group.

**5.** The electrically conductive material composition of claim 2 or 3, wherein $R^{1A}$ is hydrogen, an alkyl group, an alkoxy group, or an acyl group.

**6.** The electrically conductive material composition of claim 2 or 3, wherein $R^{1A}$ is hydrogen.

**7.** The electrically conductive material composition of claim 2 or 3, wherein $n^1$ is 0, $n^2$ is independently an integer from 1 to 4, $n^4$ is 1 or 2, and $R^5$ and $R^6$ are each independently hydrogen or a straight chain or branched chain alkyl group in which the number of carbon atoms is 1 to 3.

**8.** The electrically conductive material composition of claim 2 or 3, wherein $n^1$ and $n^3$ are 0, $n^2$ and $n^4$ are 1, and $R^5$ and $R^6$ are hydrogen.

**9.** A method of manufacturing the electrically conductive material composition of claim 2 or 3, comprising:

subjecting a thiophene monomer corresponding to the polythiophene compound to oxidative polymerization in the presence of an oxidizing agent; and
purifying the obtained polymerization product by using a chelate compound to prepare the electrically conductive material composition of claim 2 or 3.

**10.** The method of claim 9, wherein the oxidizing agent comprises an oxidizing agent comprising an iron atom.

**11.** The method of claim 9, wherein the chelate compound is a compound having a plurality of phosphonic acid structural moieties ($-P(=O)(OH)_2$) .

**12.** An organic thin-film solar cell having a hole transport layer comprising the electrically conductive material composition of claim 2 or 3.

FIG.1

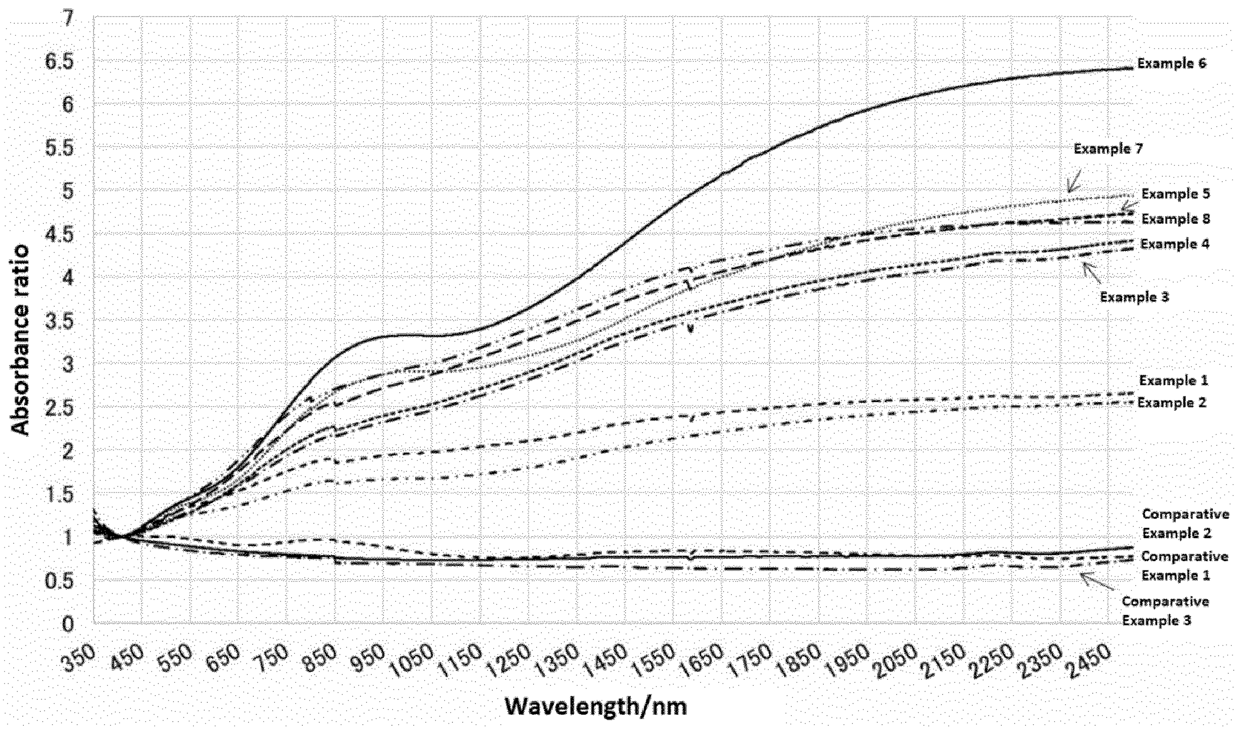
Absorbance ratio
Wavelength/nm
0
0.5
1
1.5
2
2.5
3
3.5
4
4.5
5
5.5
6
6.5
7
350
450
550
650
750
850
950
1050
1150
1250
1350
1450
1550
1650
1750
1850
1950
2050
2150
2250
2350
2450
Example 6
Example 7
Example 5
Example 8
Example 4
Example 3
Example 1
Example 2
Comparative Example 2
Comparative Example 1
Comparative Example 3

FIG.2

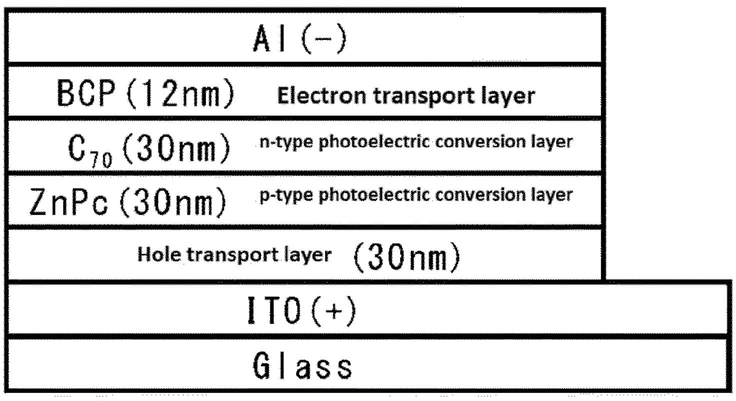
Al (-)
BCP (12nm) Electron transport layer
$C_{70}$ (30nm) n-type photoelectric conversion layer
ZnPc (30nm) p-type photoelectric conversion layer
Hole transport layer (30nm)
ITO (+)
Glass

FIG.3

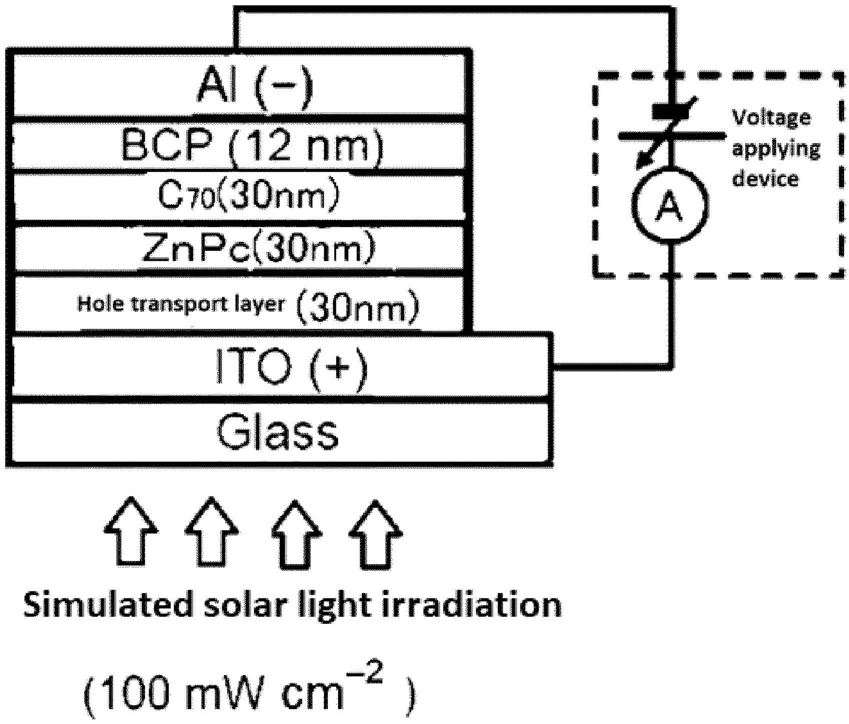
Al (−)
BCP (12 nm)
C70(30nm)
ZnPc(30nm)
Hole transport layer (30nm)
ITO (+)
Glass
Voltage applying device
A
Simulated solar light irradiation
(100 mW cm−2 )

FIG.4

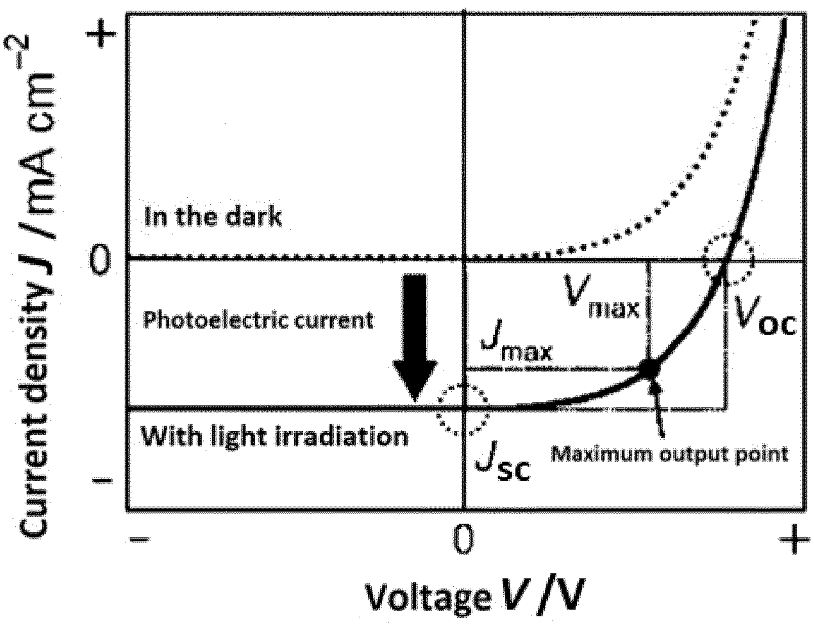
Current density J /mA cm−2
+
0
−
In the dark
Photoelectric current
With light irradiation
Vmax
Jmax
Voc
Jsc
Maximum output point
0
Voltage V /V

FIG.5

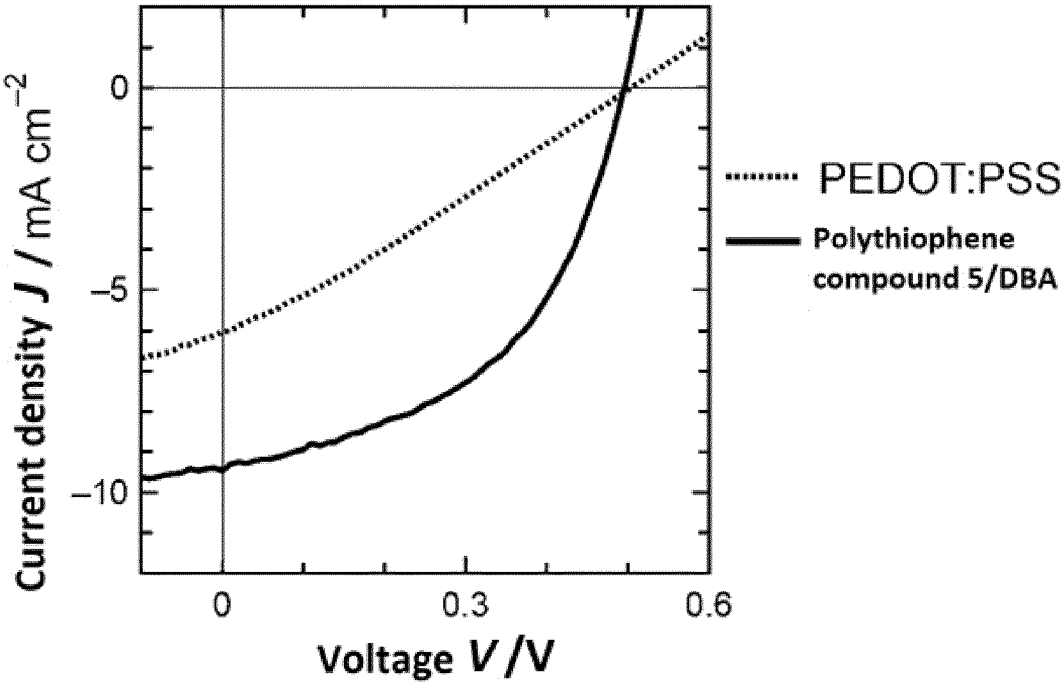
Current density J / mA cm$^{-2}$
0
−5
−10
0
0.3
0.6
Voltage V /V
PEDOT:PSS
Polythiophene compound 5/DBA

FIG.6

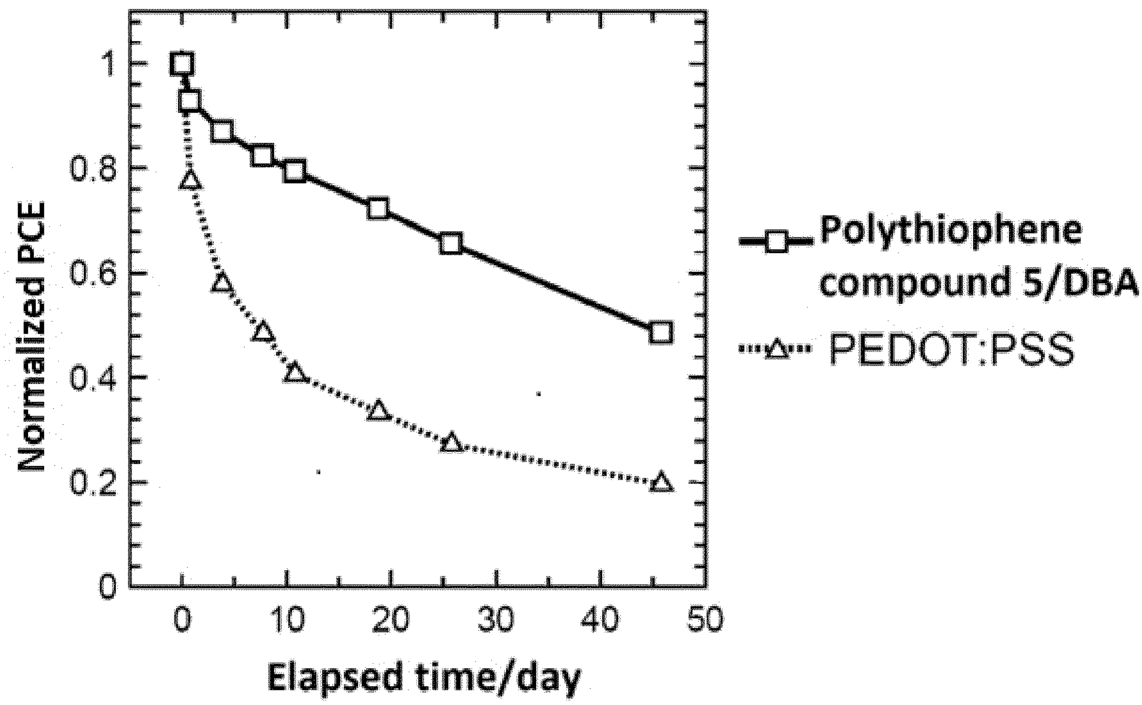
Normalized PCE
1
0.8
0.6
0.4
0.2
0
0
10
20
30
40
50
Elapsed time/day
Polythiophene compound 5/DBA
PEDOT:PSS

## INTERNATIONAL SEARCH REPORT

International application No.
**PCT/JP2022/022804**

**A. CLASSIFICATION OF SUBJECT MATTER**

***C08G 61/12***(2006.01)i; ***H01L 51/46***(2006.01)i
FI: C08G61/12; H01L31/04 150

According to International Patent Classification (IPC) or to both national classification and IPC

**B. FIELDS SEARCHED**

Minimum documentation searched (classification system followed by classification symbols)

C08G61/12; H01L51/46

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

JSTPlus/JMEDPlus/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| Y | JP 2018-48322 A (UNIV OSAKA) 29 March 2018 (2018-03-29) paragraphs [0001], [0006], [0092], [0108], example 4 (paragraph [0145]) | 1-12 |
| Y | JP 2020-105500 A (UNIV OSAKA) 09 July 2020 (2020-07-09) claims, paragraphs [0149]-[0151] | 1-12 |
| A | JP 2015-184632 A (KONICA MINOLTA INC) 22 October 2015 (2015-10-22) paragraphs [0063]-[0068] | 1-12 |
| A | JP 8-198871 A (AGENCY OF IND SCIENCE & TECHNOL) 06 August 1996 (1996-08-06) paragraph [0045] | 1-12 |
| A | WO 2006/109895 A1 (NISSAN CHEMICAL INDUSTRIES, LTD.) 19 October 2006 (2006-10-19) entire text | 1-12 |
| A | JP 2014-74007 A (TOSOH CORP) 24 April 2014 (2014-04-24) entire text | 1-12 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **25 July 2022** | **09 August 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2022/022804**

| C. DOCUMENTS CONSIDERED TO BE RELEVANT | | |
|---|---|---|
| Category* | Citation of document, with indication, where appropriate, of the relevant passages | Relevant to claim No. |
| A | US 2011/0290315 A1 (LEVON, Kalle) 01 December 2011 (2011-12-01) whole document | 1-12 |

Form PCT/ISA/210 (second sheet) (January 2015)

**INTERNATIONAL SEARCH REPORT**
**Information on patent family members**

International application No.
**PCT/JP2022/022804**

| Patent document cited in search report | Publication date (day/month/year) | Patent family member(s) | Publication date (day/month/year) |
|---|---|---|---|
| JP 2018-48322 A | 29 March 2018 | (Family: none) | |
| JP 2020-105500 A | 09 July 2020 | (Family: none) | |
| JP 2015-184632 A | 22 October 2015 | (Family: none) | |
| JP 8-198871 A | 06 August 1996 | (Family: none) | |
| WO 2006/109895 A1 | 19 October 2006 | US 2010/0019229 A1<br>whole document<br>EP 1882694 A1<br>CN 101208349 A<br>KR 10-2008-0014038 A<br>TW 200712060 A | |
| JP 2014-74007 A | 24 April 2014 | US 2015/0337061 A1<br>whole document<br>TW 201410731 A<br>CN 104428341 A<br>KR 10-2015-0035743 A | |
| US 2011/0290315 A1 | 01 December 2011 | US 2015/0101663 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2018048322 A
- JP 2020105500 A
- JP 2014074007 A


### Non-patent literature cited in the description


- *Trans. Mat. Res. Soc. Japan,* 2012, vol. 37 (2), 307-310